# EUROPEAN PATENT APPLICATION

(11) **EP 4 317 338 A1**
(43) Date of publication of application: **07.02.2024**
(21) Application number: 22774950.4
(22) Date of filing: 01.03.2022
(51) Int. Cl.: C09J 5/00, C09J 11/08, C09J 183/05, C09J 183/07, H01L 21/304, C09J 7/30, B32B 7/12

(54) **ADHESIVE COMPOSITION, LAYERED PRODUCT, METHOD FOR PRODUCING LAYERED PRODUCT, AND METHOD FOR PRODUCING SEMICONDUCTOR SUBSTRATE**

(30) Priority: 26.03.2021 JP 2021052890
(71) Applicant: Nissan Chemical Corporation, Tokyo 103-6119 (JP)
(72) Inventor: FUKUDA Takuya, Toyama-shi, Toyama 939-2792 (JP); MORIYA Shunsuke, Toyama-shi, Toyama 939-2792 (JP); OGATA Hiroto, Toyama-shi, Toyama 939-2792 (JP)
(74) Representative: Hoffmann Eitle
(86) International application number: PCT/JP2022/008678
(87) International publication number: WO 2022/202153

(57) **Abstract**

Provided is an adhesive composition which can suitably temporarily adhere a semiconductor substrate with bumps and a support substrate, can suppress or alleviate bump deformation due to an external load such as heating, and provides an adhesive layer exhibiting a high etching rate.

An adhesive composition containing an adhesive component (S), in which
the adhesive component (S) contains a polyorganosiloxane component (A) that is cured by hydrosilylation reaction, and
the polyorganosiloxane component (A) contains a polymer (V) represented by formula (V) below and having a weight average molecular weight of 60,000 or more. 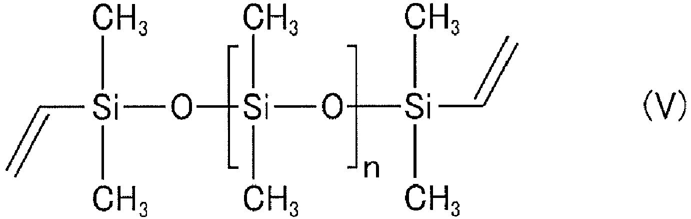 wherein n represents the number of repeating units, and is a positive integer.

## Description

### Technical Field

The present invention relates to an adhesive composition, a laminate, a method for producing a laminate, and a method for producing a semiconductor substrate.

### Background Art

For conventional semiconductor wafers that are two-dimensionally integrated in a plane direction, a semiconductor integration technology of further integrating (layering) planes of wafers in a three-dimensional direction for further integration has been required. The layering in the three-dimensional direction is a technology in which wafers are integrated into a multilayer so as to be connected with a through silicon via (TSV). When semiconductor wafers are integrated into a multilayer, each of the semiconductor wafers to be integrated is thinned by polishing a surface opposite to a surface on which a circuit is formed (i.e., a rear surface), and the thinned semiconductor wafers are layered.

A semiconductor wafer (herein, also simply referred to as a wafer) before thinning is attached to a support to be polished with a polisher.

In this case, the attachment is referred to as temporary adhesion, since the semiconductor wafer needs to be easily debonded off after polishing. The temporary adhesion requires easy detachment from the support. When a large force is applied for the detachment, a thinned semiconductor wafer may be broken or deformed, and in order to avoid this, the thinned semiconductor wafer is easily detached. However, it is also undesirable that the semiconductor wafer be detached or shifted by a polishing stress while the rear surface of the semiconductor wafer is being polished. Therefore, performance required for the temporary adhesion is the resistance to stress during polishing and easy detachment after polishing.

For example, performances such as high stress in a plane direction during polishing (high adhesion force) and low stress in a longitudinal direction during detachment (low adhesion force) are required.

Under the aforementioned circumstances, the inventors have reported an adhesive composition containing a component cured by hydrosilylation reaction and a component such as polydimethylsiloxane as an adhesive composition capable of realizing such temporary adhesion (see, for example, Patent Literatures 1 and 2).

Meanwhile, a semiconductor wafer is electrically connected to semiconductor chips by mediation of, for example, bump balls formed of a metallic conductive material. By use of chips having such bump balls, miniaturization of semiconductor packaging is achieved.

In this regard, bump balls formed of a metal such as copper or tin may be damaged or deformed by external loads such as heating and pressure applied in the process of processing a semiconductor substrate or the like, and with recent progress in the semiconductor field, a technique capable of reducing or preventing such deformation due to heating and pressure has been always required.

In addition, after the semiconductor wafer and the support are debonded, the adhesive layer left on the semiconductor wafer is dissolved and removed by, for example, wet etching using a detergent composition (cleaning liquid), and at that time, it is desired that the adhesive layer exhibits a high dissolution removal rate, that is, a high etching rate.

### Citation List

### Patent Literature

Patent Literature 1: WO 2017/221772 A
Patent Literature 2: WO 2018/216732 A

### Summary of Invention

### Technical Problem

The present invention has been made in view of the aforementioned circumstances, and an object of the present invention is to provide an adhesive composition which can suitably temporarily adhere a semiconductor substrate with bumps and a support substrate, can suppress or alleviate bump deformation due to an external load such as heating, and provides an adhesive layer exhibiting a high etching rate.

### Solution to Problem

As a result of intensive studies to solve the aforementioned problems, the present inventors have found that the aforementioned problems can be solved by containing, in an adhesive composition containing a polyorganosiloxane component (A) cured by hydrosilylation reaction, a polymer (V) having a weight average molecular weight of 60,000 or more represented by a specific formula as the polyorganosiloxane component (A), thereby completing the present invention.

That is, the present invention includes the following embodiments.
[1] An adhesive composition containing an adhesive component (S), in which
   the adhesive component (S) contains a polyorganosiloxane component (A) that is cured by hydrosilylation reaction, and
   the polyorganosiloxane component (A) contains a polymer (V) represented by formula (V) below and having a weight average molecular weight of 60,000 or more. 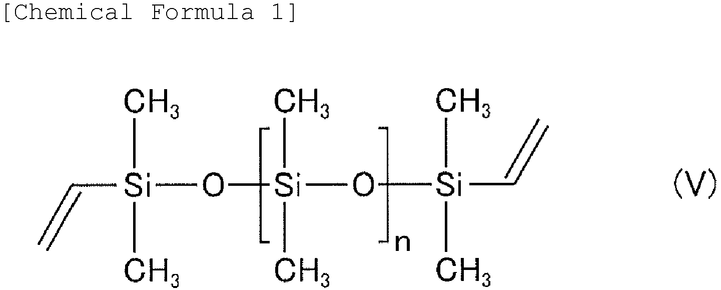
   wherein n represents the number of repeating units, and is a positive integer.
[2] The adhesive composition according to [1], containing the adhesive component (S) and a release agent component (B) containing a polyorganosiloxane.
[3] The adhesive composition according to [1] or [2], in which
   the polyorganosiloxane component (A) contains a polyorganosiloxane (A1) containing one or two or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T), and a platinum group metal catalyst (A2) (wherein R¹ to R⁶ are groups or atoms bonded to a silicon atom, and each independently represent an optionally substituted alkyl group, an optionally substituted alkenyl group, or a hydrogen atom),
   the polyorganosiloxane (A1) contains one or two or more units selected from the group consisting of a siloxane unit represented by SiO₂ (unit Q'), a siloxane unit represented by R¹'R²'R³'SiO_{1/2} (unit M'), a siloxane unit represented by R⁴'R⁵'SiO_{2/2} (unit D'), and a siloxane unit represented by R⁶'SiO_{3/2} (unit T'), and contains a polyorganosiloxane (a1) containing at least one selected from the group consisting of the unit M', unit D', and unit T', and one or two or more units selected from the group consisting of a siloxane unit represented by SiO₂ (unit Q"), a siloxane unit represented by R¹"R²"R³"SiO_{1/2} (unit M"), a siloxane unit represented by R⁴"R⁵"SiO_{2/2} (unit D"), and a siloxane unit represented by R⁶"SiO_{3/2} (unit T"), and contains a polyorganosiloxane (a2) containing at least one selected from the group consisting of the unit M", unit D", and unit T" (wherein R¹' to R⁶' are groups bonded to a silicon atom, and each independently represent an optionally substituted alkyl group or an optionally substituted alkenyl group, but at least one of R¹' to R⁶' is an optionally substituted alkenyl group, and R¹" to R⁶" are groups or atoms bonded to a silicon atom, and each independently represent an optionally substituted alkyl group or hydrogen atom, but at least one of R¹" to R⁶" is a hydrogen atom), and
   the polyorganosiloxane (a1) contains the polymer (V).
[4] The adhesive composition according to any one of [1] to [3], in which the weight average molecular weight of the polymer (V) is 100,000 or more.
[5] The adhesive composition according to [2], in which a complex viscosity of the release agent component (B) is 3,400 (Pa · s) or more.
[6] The adhesive composition according to [5], in which the release agent component (B) is a polyorganosiloxane represented by formula (M1) below: 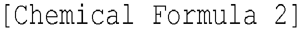 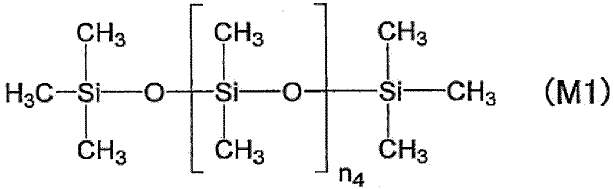 wherein n₄ represents the number of repeating units, and is a positive integer.
[7] A laminate including an adhesive layer interposed between a semiconductor substrate with bumps and a support substrate and in contact with the semiconductor substrate, in which
   the adhesive layer is a layer formed from the adhesive composition according to any one of [1] to [6].
[8] A method for producing a semiconductor substrate, including the steps of:
   processing the semiconductor substrate in the laminate according to [7]; and
   separating the support substrate and the processed semiconductor substrate from each other.
[9] A method for producing a laminate that produces the laminate according to [7], including the steps of:
   forming an adhesive coating layer that provides the adhesive layer; and
   heating the adhesive coating layer to form the adhesive layer.

### Advantageous Effects of Invention

According to the present invention, it is possible to provide an adhesive composition which can suitably temporarily adhere a semiconductor substrate with bumps and a support substrate, suppress or alleviate bump deformation due to an external load such as heating, and provides an adhesive layer exhibiting a high etching rate.

### Brief Description of Drawings

Fig. 1A is a schematic cross-sectional view of an example of a laminate.
Fig. 1B is a schematic cross-sectional view of another example of a laminate.
Fig. 2A is a view (part 1) for explaining an embodiment of producing a laminate and producing a thinned wafer.
Fig. 2B is a view (part 2) for explaining an embodiment of producing a laminate and producing a thinned wafer.
Fig. 2C is a view (part 3) for explaining an embodiment of producing a laminate and producing a thinned wafer.
Fig. 2D is a view (part 4) for explaining an embodiment of producing a laminate and producing a thinned wafer.
Fig. 2E is a view (part 5) for explaining an embodiment of producing a laminate and producing a thinned wafer.
Fig. 2F is a view (part 6) for explaining an embodiment of producing a laminate and producing a thinned wafer.

### Description of Embodiments

### (Adhesive Composition)

The adhesive composition of the present invention is a composition that can be suitably used for forming an adhesive layer for temporary adhesion for processing a semiconductor substrate.

The adhesive composition of the present invention contains an adhesive component (S).

The adhesive component (S) contains a polyorganosiloxane component (A) that is cured by hydrosilylation reaction.

The polyorganosiloxane component (A) contains a polymer (V) represented by formula (V) below and having a weight average molecular weight of 60,000 or more. 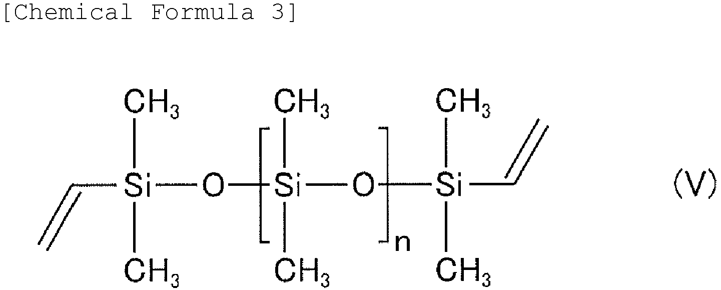 wherein n represents the number of repeating units, and is a positive integer.

The adhesive composition of the present invention preferably contains the adhesive component (S), and a release agent component (B) containing a polyorganosiloxane, in addition to the adhesive component (S) .

Also, the adhesive composition of the present invention may contain other components such as a solvent, for example, in order to adjust the viscosity and the like of the adhesive composition, in addition to the adhesive component (S) and the release agent component (B)

As shown in the following Examples, the adhesive composition of the present invention can form an adhesive layer that can suppress bump deformation and exhibits a high etching rate.

### <Adhesive Component (S)>

The adhesive component contains the polyorganosiloxane component (A) that is cured by hydrosilylation reaction.

In a more preferred embodiment of the present invention, the polyorganosiloxane component (A) contains a polyorganosiloxane (A1) containing one or two or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T), and a platinum group metal catalyst (A2).

Further, the polyorganosiloxane (A1) contains one or two or more units selected from the group consisting of a siloxane unit represented by SiO₂ (unit Q'), a siloxane unit represented by R¹'R²'R³'SiO_{1/2} (unit M'), a siloxane unit represented by R⁴'R⁵'SiO_{2/2} (unit D'), and a siloxane unit represented by R⁶'SiO_{3/2} (unit T'), and contains a polyorganosiloxane (a1) containing at least one selected from the group consisting of unit M', unit D', and unit T', and one or two or more units selected from the group consisting of a siloxane unit represented by SiO₂ (unit Q"), a siloxane unit represented by R¹"R²"R³"SiO_{1/2} (unit M"), a siloxane unit represented by R⁴"R⁵"SiO_{2/2} (unit D"), and a siloxane unit represented by R⁶"SiO_{3/2} (unit T"), and contains a polyorganosiloxane (a2) containing at least one selected from the group consisting of unit M", unit D", and unit T".

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, a heteroaryl group, and the like.

R¹' to R⁶' are groups bonded to a silicon atom, and each independently represent an optionally substituted alkyl group or an optionally substituted alkenyl group, but at least one of R¹' to R⁶' is an optionally substituted alkenyl group. Examples of the substituent include a halogen atom, a nitro group, a cyano group, an amino group, a hydroxy group, a carboxyl group, an aryl group, a heteroaryl group, and the like.

R¹" to R⁶" are groups or atoms bonded to a silicon atom, and each independently represent an optionally substituted alkyl group or hydrogen atom, but at least one of R¹" to R⁶" is a hydrogen atom. Examples of the substituent include a halogen atom, a nitro group, a cyano group, an amino group, a hydroxy group, a carboxyl group, an aryl group, a heteroaryl group, and the like.

The alkyl group may be any of linear, branched, and cyclic, but is preferably a linear or branched alkyl group, and the number of carbon atoms thereof is not particularly limited, but is generally 1 to 40, preferably 30 or less, more preferably 20 or less, and still more preferably 10 or less.

Specific examples of the optionally substituted linear or branched alkyl group include a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, and the like, but are not limited thereto, and the number of carbon atoms thereof is generally 1 to 14, preferably 1 to 10, and more preferably 1 to 6. Among them, a methyl group is particularly preferred.

Specific examples of the optionally substituted cyclic alkyl group include cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group, bicycloalkyl groups such as a bicyclobutyl group, a bicyclopentyl group, a bicyclohexyl group, a bicycloheptyl group, a bicyclooctyl group, a bicyclononyl group, and a bicyclodecyl group, and the like, but are not limited thereto, and the number of carbon atoms thereof is generally 3 to 14, preferably 4 to 10, and more preferably 5 to 6.

The alkenyl group may be either linear or branched, and the number of carbon atoms thereof is not particularly limited, but is generally 2 to 40, and is preferably 30 or less, more preferably 20 or less, and still more preferably 10 or less.

Specific examples of the optionally substituted linear or branched alkenyl group include a vinyl group, an allyl group, a butenyl group, a pentenyl group, and the like, but are not limited thereto, and the number of carbon atoms thereof is generally 2 to 14, preferably 2 to 10, and more preferably 1 to 6. Among them, an ethenyl group and a 2-propenyl group are particularly preferred.

Specific examples of the optionally substituted cyclic alkenyl group include, but are not limited to, cyclopentenyl, cyclohexenyl, and the like, and the number of carbon atoms thereof is generally 4 to 14, preferably 5 to 10, and more preferably 5 to 6.

As described above, the polyorganosiloxane (A1) contains the polyorganosiloxane (a1) and the polyorganosiloxane (a2), and the alkenyl group contained in the polyorganosiloxane (a1) and the hydrogen atom (Si-H group) contained in the polyorganosiloxane (a2) form a crosslinked structure by hydrosilylation reaction by the platinum group metal catalyst (A2) and are cured. As a result, a cured film is formed.

The polyorganosiloxane (a1) contains one or two or more units selected from the group consisting of unit Q', unit M', unit D', and unit T', and contains at least one selected from the group consisting of unit M', unit D', and unit T'. Two or more polyorganosiloxanes satisfying such conditions may be used in combination as the polyorganosiloxane (a1).

The polymer represented by formula (V) below is classified into the polyorganosiloxane (a1) in the polyorganosiloxane (A1) described above.

The adhesive composition of the present invention contains the polymer (V) represented by formula (V) below and having a weight average molecular weight of 60,000 or more as an essential component.

That is, the weight average molecular weight of the polymer represented by formula (V) contained in the adhesive composition of the present invention is 60,000 or more.

The adhesive composition of the present invention may contain one or two or more polyorganosiloxanes contained in the polyorganosiloxane (a1) in addition to the polymer represented by formula (V).

The polymer (V) will be described in detail below. 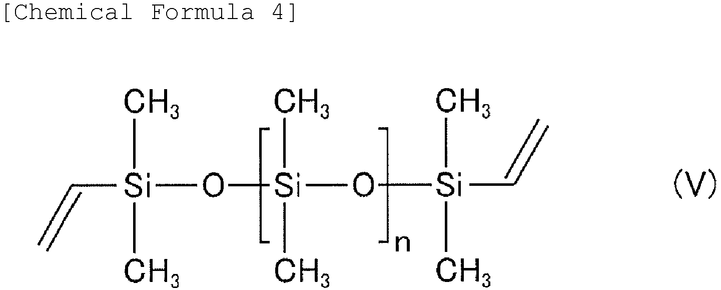 wherein n represents the number of repeating units, and is a positive integer.

Examples of preferred combinations of two or more selected from the group consisting of unit Q', unit M', unit D', and unit T' include, but are not limited to, (unit Q' and unit M'), (unit D' and unit M'), (unit T' and unit M'), and (unit Q', unit T', and unit M').

Moreover, in the case where the polyorganosiloxane (a1) contains two or more polyorganosiloxanes, a combination of (unit Q' and unit M') and (unit D' and unit M'), a combination of (unit T' and unit M') and (unit D' and unit M'), and a combination of (unit Q', unit T', and unit M') and (unit T' and unit M') are preferred, but the combination is not limited thereto.

The polyorganosiloxane (a2) contains one or two or more units selected from the group consisting of unit Q", unit M", unit D", and unit T", and contains at least one selected from the group consisting of unit M", unit D", and unit T". Two or more polyorganosiloxanes satisfying such conditions may be used in combination as the polyorganosiloxane (a2').

Examples of preferred combinations of two or more selected from the group consisting of unit Q", unit M", unit D", and unit T" include, but are not limited to, (unit M" and unit D"), (unit Q" and unit M"), and (unit Q", unit T", and unit M").

The polyorganosiloxane (a1) is composed of siloxane units in which an alkyl group and/or an alkenyl group is bonded to a silicon atom thereof, and the ratio of alkenyl groups in all substituents represented by R¹' to R⁶' is preferably 0.1 to 50.0 mol%, and more preferably 0.5 to 30.0 mol%, and the remaining R¹' to R⁶' can be alkyl groups.

The polyorganosiloxane (a2) is composed of siloxane units in which an alkyl group and/or a hydrogen atom is bonded to a silicon atom thereof, and the ratio of hydrogen atoms in all substituents represented by R¹" to R⁶" and the substituted atoms is preferably 0.1 to 50.0 mol%, and more preferably 10.0 to 40.0 mol%, and the remaining R¹" to R⁶" can be alkyl groups.

In the case where the component (A) contains (a1) and (a2), in a preferred embodiment of the present invention, the molar ratio of alkenyl groups contained in the polyorganosiloxane (a1) and hydrogen atoms forming Si-H bonds contained in the polyorganosiloxane (a2) is in the range of 1.0: 0.5 to 1.0: 0.66.

The polymer (V) is represented by formula (V), and the weight average molecular weight thereof is 60,000 or more, and more preferably 100,000 or more. The weight average molecular weight is generally 60,000 to 1,000,000, and more preferably 100,000 to 1,000,000.

The weight average molecular weight of each of polyorganosiloxanes other than the polymer (V) in the polyorganosiloxane (a1) is, not particularly limited, but generally 500 to 1,000,000, and preferably 5,000 to 50,000, from the viewpoint of attaining the effects of the present invention at high reproducibility.

The weight average molecular weight of the polyorganosiloxane (a2) is not particularly limited, but is generally 500 to 1,000,000, and preferably 5,000 to 50,000, from the viewpoint of attaining the effects of the present invention at high reproducibility.

Meanwhile, in the present invention, the weight average molecular weight, number average molecular weight, and dispersion degree of the polyorganosiloxane can be measured, for example, using a GPC apparatus (EcoSEC, HLC-8320GPC manufactured by Tosoh Corporation) and a GPC column (TSKgel SuperMultipore HZ-N and TSKgel SuperMultipore HZ-H manufactured by Tosoh Corporation), at a column temperature of 40°C and a flow rate of 0.35 mL/min by use of tetrahydrofuran as an eluent (elution solvent) and polystyrene (Shodex manufactured by Showa Denko K.K.) as a standard sample.

The viscosity of each of the polyorganosiloxane (a1) and the polyorganosiloxane (a2) is not particularly limited, but is generally 10 to 1,000,000 (mPa · s), and preferably 50 to 200,000 (mPa · s), from the viewpoint of attaining the effects of the present invention at high reproducibility. The viscosity of each of the polyorganosiloxane (a1) and the polyorganosiloxane (a2) is a value measured at 25°C by means of an E-type rotary viscometer.

The polyorganosiloxane (a1) and the polyorganosiloxane (a2) react with each other by hydrosilylation reaction to form a cured film. Therefore, the curing mechanism differs from the mechanism of curing mediated by, for example, silanol groups, and thus, neither of the siloxanes is required to have a silanol group or a functional group forming a silanol group through hydrolysis, such as an alkyloxy group.

In a preferred embodiment of the present invention, the adhesive component (S) contains the polyorganosiloxane component (A1) and the platinum group metal catalyst (A2).

Such a platinum-based metal catalyst is a catalyst for promoting the hydrosilylation reaction between alkenyl groups of the polyorganosiloxane (a1) and Si-H groups of the polyorganosiloxane (a2).

Specific examples of the platinum-based metal catalyst include, but are not limited to, platinum catalysts such as platinum black, platinum(II) chloride, chloroplatinic acid, a reaction product of chloroplatinic acid and a monohydric alcohol, a chloroplatinic acid-olefin complex, and platinum bisacetoacetate.

Examples of the platinum-olefin complex include, but are not limited to, a divinyltetramethyldisiloxane-platinum complex.

The amount of platinum group metal catalyst (A2) is not particularly limited, but is generally in the range of 1.0 to 50.0 ppm with respect to the total amount of the polyorganosiloxane (a1) and the polyorganosiloxane (a2).

The polyorganosiloxane component (A) may contain a polymerization inhibitor (A3) for the purpose of suppressing progress of the hydrosilylation reaction.

The polymerization inhibitor is not particularly limited as long as it can suppress the progress of the hydrosilylation reaction, and specific examples thereof include alkynyl alcohols such as 1-ethynyl-1-cyclohexanol and 1,1-diphenyl-2-propyn-1-ol.

The amount of polymerization inhibitor with respect to the total amount of the polyorganosiloxane (a1) and the polyorganosiloxane (a2) is not particularly limited, but is generally 1,000.0 ppm or more from the viewpoint of obtaining the effect, and 10,000.0 ppm or less from the viewpoint of preventing excessive suppression of the hydrosilylation reaction.

### <<Polymer (V)>>

The adhesive composition of the present invention contains the polymer (V) represented by formula (V) below and having a weight average molecular weight of 60,000 or more serving as the aforementioned polyorganosiloxane (a1) constituting the polyorganosiloxane component (A) cured by hydrosilylation reaction. 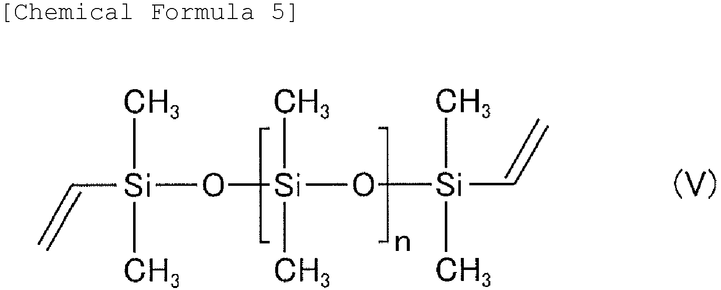 wherein n represents the number of repeating units, and is a positive integer.

The polymer represented by formula (V) may be a commercially available product or a synthesized product. Examples of the commercially available product of the polymer represented by formula (V) include products manufactured by Wacker Chemie AG.

When the weight average molecular weight of the commercially available polymer represented by formula (V) is a desired value, one polymer may be used alone as it is, or two or more polymers represented by formula (V) having different weight average molecular weights may be used in combination so that the weight average molecular weight becomes a desired value.

In addition, when the weight average molecular weight of the synthesized polymer represented by formula (V) is a desired value, one polymer may be used alone as it is, or two or more polymers represented by formula (V) having different weight average molecular weights and synthesized separately may be used in combination so that the weight average molecular weight becomes a desired value.

Further, a commercially available product and a synthesized product may be used in combination.

The weight average molecular weight of the polymer (V) is preferably 100,000 or more.

That is, by using the adhesive composition containing the polymer (V) represented by formula (V) and having a weight average molecular weight of 100,000 or more, an adhesive layer exhibiting a more excellent bump deformation suppressing effect and a higher etching rate can be formed at high reproducibility.

From the viewpoint of exhibiting both a good bump deformation suppressing effect and a high etching rate in a more balanced manner, the weight average molecular weight of the polymer (V) is preferably 160,000 or less, more preferably 150,000 or less, still more preferably 130,000 or less, and further preferably 110,000 or less.

Also, the molecular weight distribution of the polymer (V) determined from the weight average molecular weight (Mw) and the number average molecular weight (Mn) (Mw/Mn) is preferably 3.2 to 25, more preferably 3.2 to 15, and still more preferably 9 to 13 from the viewpoint of exhibiting both a good bump deformation suppressing effect and a high etching rate in a more balanced manner.

In the present invention, in order to obtain the polymer (V) having a weight average molecular weight of 60,000 or more, two or more polymers having different molecular weight regions included in formula (V) are used, and these polymers are mixed as raw materials, whereby a polymer (V) having a desired weight average molecular weight can be prepared at high reproducibility, and as a result, a good bump deformation suppressing effect and a high etching rate can be attained at high reproducibility.

Examples of the method for obtaining the polymer (V) can include the following method.
(i) By mixing and using the polymer (V2) represented by formula (V) and having a weight average molecular weight of 15,000 to 20,000 and the polymer (V1) represented by formula (V) and having a weight average molecular weight of 100,000 to 200,000 as raw materials, the polymer (V) represented by formula (V) and having a weight average molecular weight of 60,000 or more can be obtained.

Examples of a more preferred embodiment of the method for obtaining the polymer (V) can include the following method.
(i-a) In the method (i), the mixing ratio of the polymer (V2) and the polymer (V1) is set to polymer (V2): polymer (V1) = 0.04 to 1.1: 1 by mass ratio.
(i-b) In the method (i), the mixing ratio of the polymer (V2) and the polymer (V1) is set to polymer (V2): polymer (V1) = 0.04 to 0.5: 1 by mass ratio.
(i-c) In the method (i), the mixing ratio of the polymer (V2) and the polymer (V1) is set to polymer (V2): polymer (V1) = 0.3 to 0.5: 1 by mass ratio.

According to the method (i-b), the polymer (V) having a weight average molecular weight of 100,000 or more can be obtained at high reproducibility. When the polymer (V) obtained by the method (i-b) is used, an adhesive layer exhibiting a more excellent bump deformation suppressing effect can be formed at high reproducibility as compared with the case of using the polymer (V) obtained by the method (i-a).

Further, according to the method (i-c), the polymer (V) having a weight average molecular weight of 100,000 to 130,000 can be obtained at high reproducibility. When the polymer (V) obtained by the method (i-c) is used, an adhesive layer exhibiting a more excellent bump deformation suppressing effect and a higher etching rate can be formed at high reproducibility as compared with the case of using the polymer (V) obtained by the method (i-a).

Furthermore, examples of a more specific method of the method (i) can include the following method.

(ii) By mixing and using the polymer (V2-1) represented by formula (V) and having a weight average molecular weight of about 16,000 and the polymer (V1-1) represented by formula (V) and having a weight average molecular weight of about 150,000 as raw materials, the polymer (V) having a weight average molecular weight of 60,000 or more can be obtained.

Examples of a more preferred embodiment of the method for obtaining the polymer (V) can include the following method.
(ii-a) In the method (ii), the mixing ratio of the polymer (V2-1) and the polymer (V1-1) is set to polymer (V2-1): polymer (V1-1) = 0.04 to 1.1: 1 by mass ratio.
(ii-b) In the method (ii), the mixing ratio of the polymer (V2) and the polymer (V1-1) is set to polymer (V2-1): polymer (V1-1) = 0.04 to 0.5: 1 by mass ratio.
(ii-c) In the method (ii), the mixing ratio of the polymer (V2) and the polymer (V1-1) is set to polymer (V2-1): polymer (V1-1) = 0.3 to 0.5: 1 by mass ratio.

According to the method (ii-b), the polymer (V) having a weight average molecular weight of 100,000 or more can be obtained at higher reproducibility. When the polymer (V) obtained by the method (ii-b) is used, an adhesive layer exhibiting a more excellent bump deformation suppressing effect can be formed at higher reproducibility as compared with the case of using the polymer (V) obtained by the method (ii-a).

Further, according to the method (ii-c), the polymer (V) having a weight average molecular weight of 100,000 to 130,000 can be obtained at higher reproducibility. When the polymer (V) obtained by the method (ii-c) is used, an adhesive layer exhibiting a more excellent bump deformation suppressing effect and a higher etching rate can be formed at higher reproducibility as compared with the case of using the polymer (V) obtained by the method (ii-a).

The method for mixing polymers in the case of using two or more polymers having different molecular weight regions included in formula (V) is not particularly limited, but generally, the mixing ratio is determined so as to have a desired weight average molecular weight, and the polymers are well mixed using an agitator. At this time, when the amount of polymer to be used is small, it is not possible to sufficiently mix the polymers, and it is not possible to obtain a polymer with high uniformity at high reproducibility, so that this point is noted.

The mixing ratio for obtaining a desired weight average molecular weight can be appropriately determined by those skilled in the art in consideration of the weight average molecular weight of each polymer to be used without excessive trial and error.

In addition, since it is enough that the weight average molecular weight of the polymer represented by formula (V) contained in the adhesive composition is a desired value, in the case of using two or more polymers represented by formula (V) having different molecular weight regions are used, for example, a part of the two or more polymers may be well mixed with a component other than the polymer constituting the adhesive composition, and then the remaining polymer may be added to the obtained mixture and thoroughly mixed to prepare the adhesive composition.

That is, in the preparation of the adhesive composition, the polymer (V) does not need to be prepared as an individual polymer before the preparation, and in the process of preparing the adhesive composition, two or more polymers represented by formula (V) that do not have a desired weight average molecular weight may be mixed to finally realize the polymer (V) in the adhesive composition.

Furthermore, in order to adjust the polymerization average molecular weight of the polymer (V-1) as the polymer (V), the polymer (V-1) may be a polymer (V-2) as the polymer (V) by mixing one or two or more polymers represented by formula (V) having different weight average molecular weights.

In the present invention, as represented by formula (V), it is preferable to contain a polyorganosiloxane having a vinyl group at a terminal, the polyorganosiloxane having no vinyl group bonded to other than the terminal.

Moreover, the object of the present invention can be achieved by containing, particularly, a polymer having a large molecular weight such as a weight average molecular weight of 60,000 or more, among the polymers represented by formula (V). It is presumed that crosslinking of a polymer having a high weight average molecular weight, such as the polymer (V), by hydrosilylation reaction leads to an effect that protective performance of the bump can be improved at the time of external heating and pressurization, and a detergent composition easily permeates the film at the time of cleaning.

In the polymer represented by formula (V), it is not denied that a polymer containing a group other than a - Si(CH₃)₂CHCH₂ group or a -Si(CH₃)₂-O- group as a trace impure structure at a terminal or in the middle of the repeating unit is present in bulk of the polymer.

### <Release Agent Component (B)>

The adhesive composition of the present invention may contain a release agent component (B) containing a polyorganosiloxane (hereinafter, also referred to as a component (B)), in addition to the aforementioned adhesive component (S).

As a preferred embodiment, the adhesive composition of the present invention contains, as the adhesive component (S), a polyorganosiloxane component (A) (hereinafter, also referred to as a component (A)) as a component to be cured, and a component (B) which does not cause a curing reaction as a release agent component.

Here, the phrase "does not cause a curing reaction" does not mean not causing any curing reaction, but means not causing a curing reaction occurring in the component (A) to be cured.

By containing the component (B) in the adhesive composition, the resulting adhesive layer can be suitably debonded off at high reproducibility.

Typical examples of such a release agent component (B) include, but are not limited to, polyorganosiloxanes, and specific examples thereof include epoxy group-containing polyorganosiloxanes, methyl group-containing polyorganosiloxanes, phenyl group-containing polyorganosiloxanes, and the like.

Also, examples of the release agent component (B) include polydimethylsiloxane. The polydimethylsiloxane may be modified. Examples of the polydimethylsiloxane that may be modified include, but are not limited to, an epoxy group-containing polydimethylsiloxane, unmodified polydimethylsiloxanes, a phenyl group-containing polydimethylsiloxane, and the like.

The weight average molecular weight of the polyorganosiloxane as the release agent component (B) is not particularly limited, but is generally 100,000 to 2,000,000, and is preferably 200,000 to 1,200,000, and more preferably 300,000 to 900,000 from the viewpoint of attaining the effects of the present invention at high reproducibility. Moreover, the dispersion degree (Mw/Mn) is not particularly limited, but is generally 1.0 to 10.0, and is preferably 1.5 to 5.0, and more preferably 2.0 to 3.0 from the viewpoint of attaining suitable debonding at high reproducibility. The weight average molecular weight and the dispersion degree can be measured by the aforementioned method relating to polyorganosiloxane.

Examples of the epoxy group-containing polyorganosiloxane include those containing a siloxane unit represented by R¹¹R¹²SiO_{2/2} (unit D¹⁰).

R¹¹ is a group bonded to a silicon atom and represents an alkyl group, R¹² is a group bonded to a silicon atom and represents an epoxy group or an organic group containing an epoxy group, and specific examples of the alkyl group can include the aforementioned examples.

The epoxy group in the organic group containing an epoxy group may be an independent epoxy group without being fused with another ring, or may be an epoxy group forming a fused ring with another ring, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane include, but are not limited to, an epoxy group-containing polydimethylsiloxane.

The epoxy group-containing polyorganosiloxane contains the aforementioned siloxane unit (unit D¹⁰), but may contain unit Q, unit M, and/or unit T in addition to unit D¹⁰.

In a preferred embodiment of the present invention, specific examples of the epoxy group-containing polyorganosiloxane include polyorganosiloxanes composed only of unit D¹⁰, polyorganosiloxanes containing unit D¹⁰ and unit Q, polyorganosiloxanes containing unit D¹⁰ and unit M, polyorganosiloxanes containing unit D¹⁰ and unit T, polyorganosiloxanes containing unit D¹⁰, unit Q, and unit M, polyorganosiloxanes containing unit D¹⁰, unit M, and unit T, polyorganosiloxanes containing unit D¹⁰, unit Q, unit M, and unit T, and the like.

The epoxy group-containing polyorganosiloxane is preferably an epoxy group-containing polydimethylsiloxane having an epoxy value of 0.1 to 5. Also, the weight average molecular weight thereof is not particularly limited, but is generally 1,500 to 500,000, and is preferably 100,000 or less from the viewpoint of suppressing precipitation in the adhesive.

Specific examples of the epoxy group-containing polyorganosiloxane include, but are not limited to, those represented by formulae (E1) to (E3): 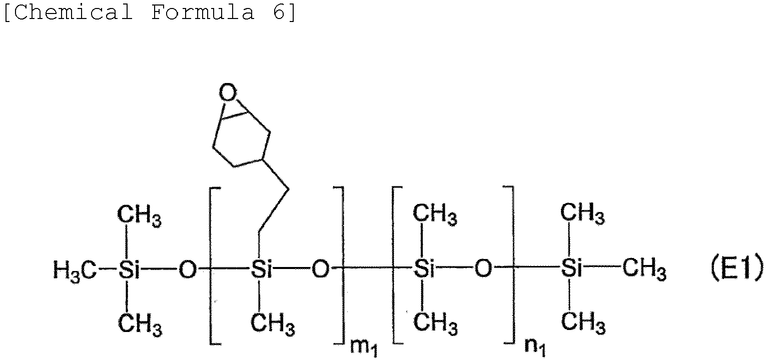 wherein each of m₁ and n₁ represents the number of repeating units, and is a positive integer, 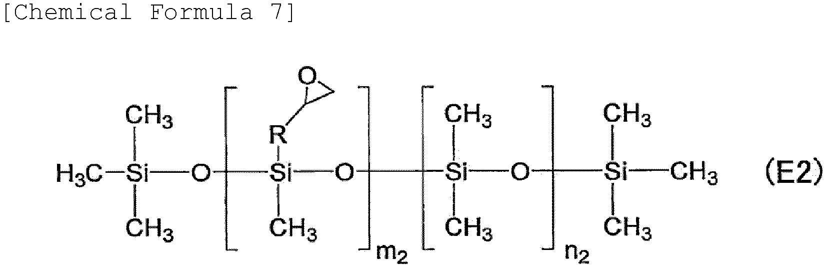 wherein each of m₂ and n₂ represents the number of repeating units, and is a positive integer, and R is an alkylene group having 1 to 10 carbon atoms, and 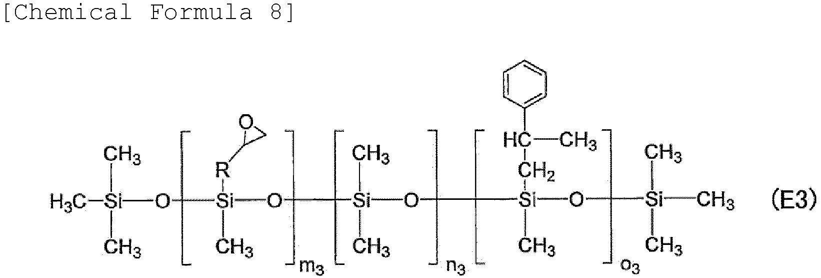 wherein each of m₃, n₃, and o₃ represents the number of repeating units, and is a positive integer, and R is an alkylene group having 1 to 10 carbon atoms.

Examples of the methyl group-containing polyorganosiloxane include those containing a siloxane unit represented by R²¹⁰R²²⁰SiO_{2/2} (unit D²⁰⁰), and preferably those containing a siloxane unit represented by R²¹R²¹SiO_{2/2} (unit D²⁰).

R²¹⁰ and R²²⁰ are groups bonded to a silicon atom and each independently represent an alkyl group, but at least one thereof is a methyl group, and specific examples of the alkyl group can include the aforementioned examples.

R²¹ is a group bonded to a silicon atom and represents an alkyl group, and specific examples of the alkyl group can include the aforementioned examples. Among them, R²¹ is preferably a methyl group.

In the present invention, preferred examples of the methyl group-containing polyorganosiloxane include, but are not limited to, polydimethylsiloxane.

The methyl group-containing polyorganosiloxane contains the aforementioned siloxane unit (unit D²⁰⁰ or unit D²⁰), but may contain unit Q, unit M, and/or unit T in addition to unit D²⁰⁰ and unit D²⁰.

In an embodiment of the present invention, specific examples of the methyl group-containing polyorganosiloxane include polyorganosiloxanes composed only of unit D²⁰⁰, polyorganosiloxanes containing unit D²⁰⁰ and unit Q, polyorganosiloxanes containing unit D²⁰⁰ and unit M, polyorganosiloxanes containing unit D²⁰⁰ and unit T, polyorganosiloxanes containing unit D²⁰⁰, unit Q, and unit M, polyorganosiloxanes containing unit D²⁰⁰, unit M, and unit T, and polyorganosiloxanes containing unit D²⁰⁰, unit Q, unit M, and unit T.

In a preferred embodiment of the present invention, specific examples of the methyl group-containing polyorganosiloxane include polyorganosiloxanes composed only of unit D²⁰, polyorganosiloxanes containing unit D²⁰ and unit Q, polyorganosiloxanes containing unit D²⁰ and unit M, polyorganosiloxanes containing unit D²⁰ and unit T, polyorganosiloxanes containing unit D²⁰, unit Q, and unit M, polyorganosiloxanes containing unit D²⁰, unit M, and unit T, and polyorganosiloxanes containing unit D²⁰, unit Q, unit M, and unit T.

Specific examples of the methyl group-containing polyorganosiloxane include, but are not limited to, those represented by formula (M1): 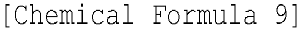 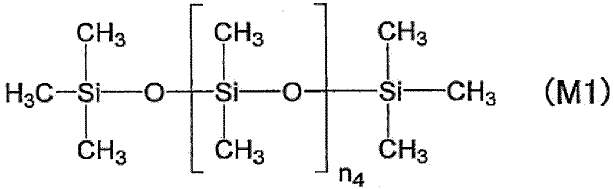 wherein n₄ represents the number of repeating units, and is a positive integer.

Examples of the phenyl group-containing polyorganosiloxane include those containing a siloxane unit represented by R³¹R³²SiO_{2/2} (unit D³⁰).

R³¹ is a group bonded to a silicon atom and represents a phenyl group or an alkyl group, R³² is a group bonded to a silicon atom and represents a phenyl group, and specific examples of the alkyl group include the aforementioned examples, but a methyl group is preferred.

The phenyl group-containing polyorganosiloxane contains the aforementioned siloxane unit (unit D³⁰), but may contain unit Q, unit M, and/or unit T in addition to unit D³⁰.

In a preferred embodiment of the present invention, specific examples of the phenyl group-containing polyorganosiloxane include polyorganosiloxanes composed only of unit D³⁰, polyorganosiloxanes containing unit D³⁰ and unit Q, polyorganosiloxanes containing unit D³⁰ and unit M, polyorganosiloxanes containing unit D³⁰ and unit T, polyorganosiloxanes containing unit D³⁰, unit Q, and unit M, polyorganosiloxanes containing unit D³⁰, unit M, and unit T, and polyorganosiloxanes containing unit D³⁰, unit Q, unit M, and unit T.

Specific examples of the phenyl group-containing polyorganosiloxane include, but are not limited to, those represented by formula (P1) or (P2): 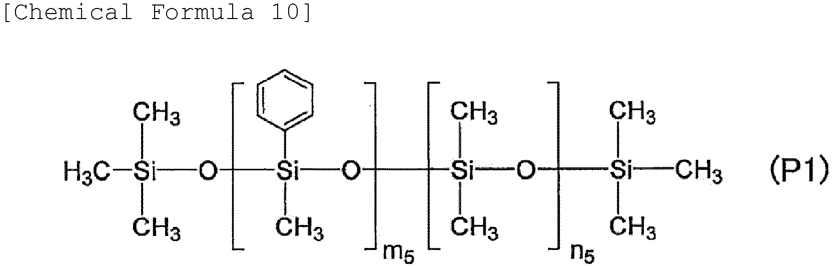 wherein each of m₅ and n₅ represents the number of repeating units, and is a positive integer, and 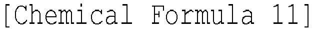 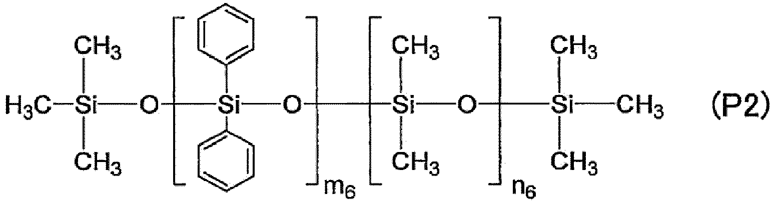 wherein each of m₆ and n₆ represents the number of repeating units, and is a positive integers.

The polyorganosiloxane as the release agent component (B) may be a commercially available product or a synthetic product.

Examples of commercially available products of the polyorganosiloxane include, but are not limited to, WACKERSILICONE FLUID AK series (AK50, AK 350, AK 1000, AK 10,000, AK 1000000) and GENIOPLAST GUM, which are products manufactured by Wacker Chemie AG, dimethyl silicone oils (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxanes manufactured by Gelest, Inc. (trade name: CMS-227, ECMS-327), epoxy group-containing polyorganosiloxanes manufactured by Shin-Etsu Chemical Co., Ltd. (KF-101, KF-1001, KF-1005, X-22-343), epoxy group-containing polyorganosiloxane manufactured by Dow Corning (BY16-839); phenyl group-containing polyorganosiloxanes (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., phenyl group-containing polyorganosiloxane (TSF431, TSF433) manufactured by Momentive Performance Materials, and the like.

As a preferred embodiment of the present invention, the adhesive composition of the present invention contains the adhesive component (S), and the release agent component (B) containing a polyorganosiloxane, which does not cause a curing reaction. Among these adhesive compositions, an adhesive composition containing a release agent component (H) containing a polyorganosiloxane having a complex viscosity of 3,400 (Pa · s) or more as the release agent component (B) is more preferred.

Here, in the present invention, particularly, the complex viscosity of the polyorganosiloxane as the release agent component (H) means a value measured using a rheometer at 25°C. Such a complex viscosity can be measured using, for example, a rheometer MCR-302 manufactured by Anton Paar GmbH.

The adhesive composition of the present invention is preferably an adhesive composition containing the release agent component (H) as the release agent component (B), but can contain one or two or more release agent components contained in the release agent component (B) in addition to the release agent component (H).

The complex viscosity of the polyorganosiloxane as the release agent component (H) is 3,400 (Pa · s) or more as described above, but is preferably 4,000 (Pa · s) or more, more preferably 4,500 (Pa · s) or more, still more preferably 5,000 (Pa · s) or more, and further preferably 5,500 (Pa · s) or more from the viewpoint of attaining the effects of the present invention at high reproducibility, and is generally 30,000 (Pa · s) or less, preferably 25,000 (Pa · s) or less, more preferably 20,000 (Pa · s) or less, still more preferably 15,000 (Pa · s) or less, and further preferably 10,000 (Pa · s) or less from the viewpoint of ensuring solubility in an organic solvent when the organic solvent is used for preparing the adhesive composition.

As the adhesive composition of the present invention, by containing the polymer (V) and the release agent component (H) described above, it is possible to suppress bump deformation and more reliably form an adhesive layer exhibiting a high etching rate.

In an example of the adhesive composition of the present invention, the mass ratio of the adhesive component (S) to the release agent component (B) is generally adhesive component (S): release agent component (B) = 5: 95 to 95: 5, but is preferably 50: 50 to 93: 7, more preferably 60: 40 to 91: 9, more preferably 65: 35 to 89: 11, still more preferably 70: 30 to 87: 13, and further preferably 75: 25 to 85: 15.

### <Other Components>

The adhesive composition of the present invention may contain a solvent for the purpose of adjusting the viscosity and the like, and specific examples of the solvent include, but are not limited to, aliphatic hydrocarbons, aromatic hydrocarbons, ketones, and the like.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, 5-nonanone, and the like. Such solvents can be used singly or in combination of two or more thereof.

In the case where the adhesive composition of the present invention contains a solvent, the content thereof is appropriately determined in consideration of the desired viscosity of the composition, the coating method to be employed, the thickness of the film to be prepared, and the like, but is in the range of about 10 to 90% by mass with respect to the entire composition.

The viscosity of the adhesive composition of the present invention is not particularly limited, but is generally 500 to 20,000 mPa · s and preferably 1,000 to 6,000 mPa · s at 25°C. The viscosity of the adhesive composition of the present invention can be adjusted by changing the type of solvent to be used, the ratio thereof, the film constituent concentration, and the like, in consideration of various factors such as the coating method to be used and the desired film thickness.

In the present invention, the film constituent means a component other than the solvent contained in the composition.

### <Method for Producing Adhesive Composition>

As a preferred embodiment of the method for producing an adhesive composition, for example, the adhesive composition of the present invention can be produced by mixing the adhesive component (S), the release agent component (B), and a solvent when used.

The mixing order is not particularly limited, but examples of the method by which the adhesive composition of the present invention can be easily and reproducibly produced include, but are not limited to, a method in which the adhesive component (S) and the release agent component (B) are dissolved in a solvent, and a method in which a part of the adhesive component (S) and the release agent component (B) is dissolved in a solvent, the rest is dissolved in a solvent, and the resulting solutions are mixed. When the adhesive composition is prepared, the adhesive composition may be appropriately heated as long as the components are not decomposed or deteriorated.

In the present invention, for the purpose of removing foreign substances, filtration may be performed using a filter or the like during the production of the adhesive composition or after mixing all the components.

### (Laminate)

The laminate of the present invention includes a semiconductor substrate with bumps, a support substrate, and an adhesive layer.

The adhesive layer is interposed between the semiconductor substrate with bumps and the support substrate and is in contact with the semiconductor substrate.

The adhesive layer is a layer formed from the adhesive composition of the present invention described above.

The laminate is used for temporary adhesion for processing a semiconductor substrate, and can be suitably used for applications in which the support substrate and the semiconductor substrate are separated after processing the semiconductor substrate in the laminate.

In the laminate of the present invention, the number of layers of the adhesive layer is not particularly limited, and is appropriately selected according to the purpose. For example, in the laminate, the adhesive layer may be one layer or two or more layers.

In addition, the laminate of the present invention may include a layer other than the adhesive layer between the semiconductor substrate and the support substrate, and examples thereof include a laminate including an adhesive layer and a release layer between the semiconductor substrate and the support substrate.

Examples of a preferred embodiment of the laminate of the present invention include a laminate having a semiconductor substrate, an adhesive layer, a release layer, and a support substrate in this order.

The laminate of the present invention has an adhesive layer which can suitably temporarily adhere a semiconductor substrate with bumps and a support substrate, can suppress or alleviate bump deformation due to an external load such as heating, and exhibits a high etching rate.

Therefore, the laminate of the present invention is a laminate having an adhesive layer that can satisfy both the bump deformation suppressing effect and the high etching rate.

Hereinafter, an example of the laminate will be described with reference to the drawings.

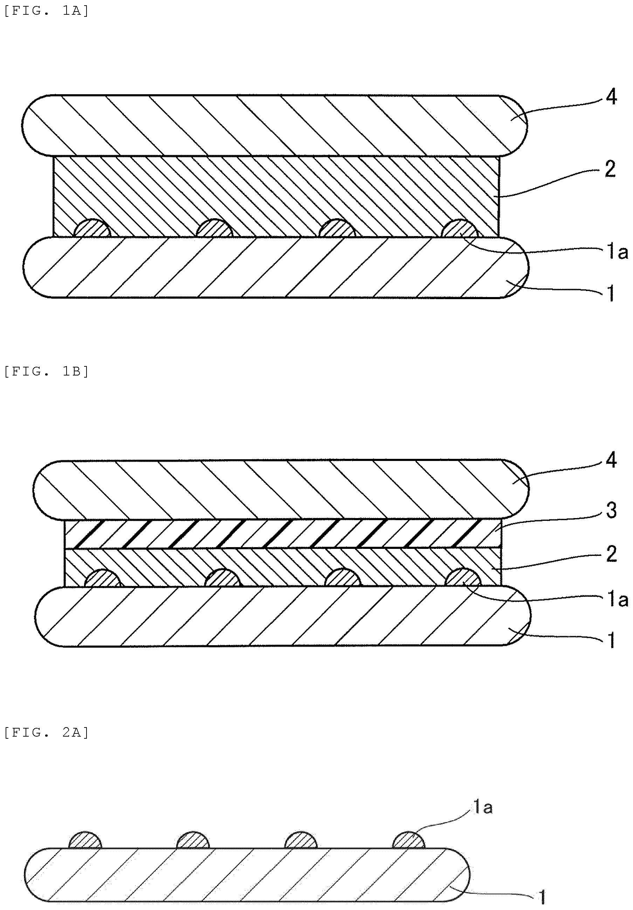

Fig. 1A is a schematic cross-sectional view of an example of a laminate.

The laminate of Fig. 1A includes a semiconductor substrate 1 having bumps 1a, an adhesive layer 2, and a support substrate 4 in this order.

The bumps 1a of the semiconductor substrate 1 are disposed on the support substrate 4 side.

The adhesive layer 2 is interposed between the semiconductor substrate 1 and the support substrate 4. The adhesive layer 2 is in contact with the semiconductor substrate 1. Then, the adhesive layer 2 covers the bumps 1a.

Fig. 1B is a schematic cross-sectional view of another example of a laminate.

The laminate of Fig. 1B includes a semiconductor substrate 1 having bumps 1a, an adhesive layer 2, a release layer 3, and a support substrate 4 in this order.

The bumps 1a of the semiconductor substrate 1 are disposed on the support substrate 4 side.

The adhesive layer 2 is interposed between the semiconductor substrate 1 and the support substrate 4. The adhesive layer 2 is in contact with the semiconductor substrate 1. Then, the adhesive layer 2 covers the bumps 1a.

The release layer 3 is interposed between the adhesive layer 2 and the support substrate 4. The release layer 3 is in contact with the adhesive layer 2 and the support substrate 4.

Each configuration of the laminate of the present invention will be described in detail below.

### <Semiconductor Substrate>

The semiconductor substrate has a bump. The bump is a protruding terminal.

In the laminate, the semiconductor substrate has the bump on the support substrate side.

In the semiconductor substrate, the bump is generally formed on a surface on which a circuit is formed. The circuit may be a single layer or a multilayer. The shape of the circuit is not particularly limited.

In the semiconductor substrate, a surface opposite to the surface having the bump (rear surface) is a surface to be subjected to processing.

A main material constituting the entire semiconductor substrate is not particularly limited as long as it is used for this type of application, and examples thereof include silicon, silicon carbide, a compound semiconductor, and the like.

The shape of the semiconductor substrate is not particularly limited, and is, for example, a disk shape. Note that the disk-shaped semiconductor substrate does not need to have a completely circular surface, and for example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, and is, for example, 500 to 1,000 um.

The diameter of the disk-shaped semiconductor substrate may be appropriately determined according to the purpose of use of the semiconductor substrate and the like, and is not particularly limited, and is, for example, 100 to 1,000 mm.

An example of the semiconductor substrate is a silicon wafer with a diameter of about 300 mm and a thickness of about 770 um.

The material, size, shape, structure, and density of the bump of the semiconductor substrate are not particularly limited.

Examples of the bump include a ball bump, a print bump, a stud bump, a plating bump, and the like.

Generally, the height, diameter, and pitch of the bump are appropriately determined from the conditions of a bump height of about 1 to 200 pm, a bump diameter of 1 to 200 um, and a bump pitch of 1 to 500 um.

Examples of the material of the bump include low melting point solder, high melting point solder, tin, indium, gold, silver, copper, and the like. The bump may be composed of only a single component or may be composed of a plurality of components. More specific examples thereof include alloy plating mainly containing Sn, such as SnAg bump, SnBi bump, Sn bump, and AuSn bump, and the like.

In addition, the bump may have a laminated structure including a metal layer including at least any one of these components.

### <Support Substrate>

The support substrate is not particularly limited as long as it is a member capable of supporting the semiconductor substrate when the semiconductor substrate is processed, and examples thereof include a glass support substrate, a silicon support substrate, and the like.

The shape of the support substrate is not particularly limited, and examples thereof include a disk shape. Note that the disk-shaped support substrate does not need to have a completely circular surface, and for example, the outer periphery of the support substrate may have a straight portion called an orientation flat or may have a cut called a notch.

The thickness of the disk-shaped support substrate may be appropriately determined according to the size of the semiconductor substrate and the like, and is not particularly limited, and is, for example, 500 to 1,000 um.

The diameter of the disk-shaped support substrate may be appropriately determined according to the size of the semiconductor substrate and the like, and is not particularly limited, and is, for example, 100 to 1,000 mm.

An example of the support substrate is a glass wafer or a silicon wafer with a diameter of 300 mm and a thickness of about 700 pmm.

In the case where the laminate includes a release layer and the release layer is irradiated with light for debonding from the support substrate side, the support substrate that transmits light is used. The light transmittance in this case is generally 50% or more, preferably 80% or more, and more preferably 90% or more. Specific examples thereof include, but are not limited to, a glass support substrate.

### <Adhesive Layer>

The adhesive layer is interposed between the support substrate and the semiconductor substrate.

The adhesive layer is in contact with the semiconductor substrate.

The adhesive layer is formed using the adhesive composition of the present invention described above, and more specifically formed by curing the adhesive composition.

The thickness of the adhesive layer is not particularly limited, but is preferably 20 to 120 µm, and more preferably 40 to 100 um from the viewpoint of obtaining a good bump deformation suppressing effect.

The method for forming the adhesive layer from the adhesive composition will be described in detail in the description of <Method for Producing Laminate> described below.

### <Release Layer>

The laminate of the present invention may include a release layer.

When the laminate has a release layer, for example, the release layer can be arranged so as to be in contact with the support substrate and the adhesive layer.

As the release layer, the type of the release layer and the debonding method are not particularly limited as long as the release layer contributes to improvement in debonding performance by heating or light irradiation and can separate the semiconductor substrate and the support substrate in the laminate, and for example, a release layer described below can be used.

The release layer is a film obtained from a release agent composition containing an organic resin and a solvent, and in one embodiment, the film is a cured film obtained by curing a film constituent in the release agent composition.

The release agent composition can further contain a crosslinking agent, an acid catalyst, and a surfactant.

The release agent composition contains an organic resin. Such an organic resin is preferably one that can exhibit a suitable debonding ability, and in the case where the semiconductor substrate and the support substrate are separated by irradiating the release layer with light, the organic resin absorbs light and is suitably deteriorated, for example, decomposed, necessary for improving the debonding ability.

A preferred example of the organic resin can include a novolac resin.

When the release layer included in the laminate of the present invention is debonded off by irradiation with light, a novolac resin that absorbs light with a wavelength of 190 nm to 600 nm and is deteriorated is preferred, and a novolac resin that is deteriorated by irradiation with light such as a laser with a wavelength of 308 nm, 343 nm, 355 nm, or 365 nm is more preferred.

As a specific example, the novolac resin is a polymer containing one or two or more types selected from the group consisting of a unit represented by formula (C1-1) below, a unit represented by formula (C1-2) below, and a unit represented by formula (C1-3) below.

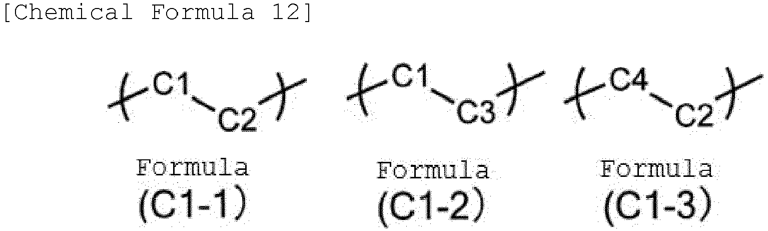

C1 represents a group derived from an aromatic compound containing a nitrogen atom, C2 represents a group containing a tertiary carbon atom having at least one selected from the group consisting of a secondary carbon atom, a quaternary carbon atom, and an aromatic ring in a side chain, C3 represents a group derived from an aliphatic polycyclic compound, and C4 represents a group derived from phenol, a group derived from bisphenol, a group derived from naphthol, a group derived from biphenyl, or a group derived from biphenol.

For a novolac resin to be contained in the release agent composition and a release layer using a novolac resin, the novolac resin described in WO 2019/088103 A and a release layer using the novolac resin can be taken into consideration.

The release layer is formed by applying the release agent composition and drying and curing the release agent composition.

The thickness of the release layer included in the laminate according to the present invention is appropriately set in consideration of the type of the release agent component, the degree of desired debonding performance, and the like, but is generally 5 to 10,000 nm, and is preferably 10 nm or more, more preferably 50 nm or more, and still more preferably 100 nm or more from the viewpoint of suppressing deterioration of debonding ability due to a thin film and obtaining a release layer excellent in debonding performance at high reproducibility, and is preferably 5,000 nm or less, more preferably 1,000 nm or less, and still more preferably 500 nm or less from the viewpoint of avoiding non-uniformity due to a thick film, and the like.

### <Method for Producing Laminate>

When the adhesive layer in the laminate is composed of only an adhesive layer formed using the adhesive composition of the present invention and a single layer, the method for producing a laminate of the present invention includes a step of forming an adhesive layer (an adhesive coating layer forming step and an adhesive layer forming step), and further includes other steps such as a bonding step as necessary. A method for producing a laminate in this case will be described in detail in the section of <<First Embodiment>> below.

In the case where the laminate includes an adhesive layer and a release layer, the method for producing a laminate of the present invention includes a step of forming a release layer in addition to a step of forming an adhesive layer (an adhesive coating layer forming step and an adhesive layer forming step), and further includes other steps such as a bonding step as necessary. A method for producing a laminate in this case will be described in detail in the section of <<Second embodiment>> below.

### <<First Embodiment>>

An adhesive layer is formed through an adhesive coating layer forming step and an adhesive layer forming step.

### <<<Adhesive Coating Layer Forming Step>>>

In the adhesive coating layer forming step, for example, the adhesive composition is applied to the semiconductor substrate with bumps to form an adhesive coating layer.

The coating method is not particularly limited, but is generally a spin coating method. Incidentally, a method of separately forming a coating film by spin coating method or the like and attaching a sheet-like coating film as an adhesive coating layer can be adopted.

The thickness of the adhesive coating layer is appropriately determined in consideration of the thickness of the adhesive layer in the laminate, and the like.

For the reason that the adhesive composition contains a solvent or the like, the applied adhesive composition may be heated for the purpose of drying the coating film of the applied adhesive composition (pre-heat treatment).

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified, but it is generally 80 to 150°C, and the heating time is generally 30 seconds to 5 minutes.

Heating can be performed using a hot plate, an oven, or the like.

### <<<Adhesive Layer Forming Step>>>

In the adhesive layer forming step, the adhesive coating layer is heated and the adhesive composition is cured to form an adhesive layer.

The adhesive layer forming step is not particularly limited as long as the adhesive layer is formed by heating the adhesive coating layer in a state where the support substrate and the adhesive coating layer are in contact with each other and the adhesive coating layer and the semiconductor substrate are in contact with each other.

For example, using a semiconductor substrate on which an adhesive coating layer is formed and a support substrate, two substrates (the semiconductor substrate and the support substrate) are arranged so as to sandwich the adhesive coating layer, the support substrate and the adhesive coating layer may be brought into contact with each other, and the adhesive coating layer and the semiconductor substrate may be brought into contact with each other, and then heat treatment may be performed (post-heat treatment).

The temperature and time of heating are not particularly limited as long as they are the temperature and time at which the adhesive coating layer is converted into the adhesive layer.

The heating temperature is preferably 120°C or higher, and more preferably 150°C or higher from the viewpoint of achieving a sufficient curing rate, and is preferably 250°C or lower from the viewpoint of preventing deterioration of layers (including the support substrate and the semiconductor substrate) constituting the laminate. The heating temperature is further preferably 180 to 200°C.

The heating time is preferably 1 minute or more, and more preferably 5 minutes or more from the viewpoint of achieving suitable bonding of the layers (including the support substrate and the semiconductor substrate) constituting the laminate, and is preferably 180 minutes or less, and more preferably 120 minutes or less from the viewpoint of suppressing or avoiding adverse effects on the layers due to excessive heating. The heating time is further preferably 1 to 20 minutes from the viewpoint of substrate treatment efficiency.

Heating can be performed using a hot plate, an oven, or the like.

### (Bonding Step)

It is preferable to perform a bonding step between the adhesive coating layer forming step and the adhesive layer forming step in order to sufficiently bond the semiconductor substrate and the support substrate.

The bonding step is not particularly limited as long as the substrate and the layer can be bonded to each other and the substrate and the layer are not damaged, but typically, the bonding step is a step in which a load can be applied in the thickness direction of the support substrate and the semiconductor substrate, and more preferably a step in which a load can be applied in the thickness direction of the support substrate and the semiconductor substrate under reduced pressure.

The load is not particularly limited as long as the substrate and the layer can be bonded to each other and the substrate and the layer are not damaged, but is, for example, 10 to 1,000 N.

The degree of pressure reduction is not particularly limited as long as the substrate and the layer can be bonded to each other and the substrate and the layer are not damaged, but is, for example, 10 to 10,000 Pa.

### <<Second Embodiments

As a preferred embodiment of the method for producing a laminate including a release layer, a method for producing a laminate will be described below by taking, as an example, a case of using a release layer formed of a release agent composition containing an organic resin such as the aforementioned novolac resin described above.

An adhesive coating layer is formed on a semiconductor substrate by a method similar to the method described in the section of the adhesive coating layer forming step in the aforementioned <<First Embodiment>>.

The release agent composition on the support substrate is applied to form a release agent coating layer, and the release agent coating layer is heated and cured to form a release layer. Here, as a coating method of the release agent composition, the same method as the coating method described in the section of the adhesive coating layer forming step of the aforementioned <<First Embodiment>> can be used.

Using a semiconductor substrate on which an adhesive coating layer is formed and a support substrate on which a release layer is formed, two substrates (the semiconductor substrate and the support substrate) are arranged so as to sandwich the two layers (the adhesive coating layer and the release layer), so that the adhesive coating layer and the release layer are brought into contact with each other, and then heat treatment may be performed.

The temperature and time of heating are not particularly limited as long as they are the temperature and time at which the adhesive coating layer is converted into the adhesive layer.

As the heating condition, the same conditions as those described in the adhesive layer forming step of the aforementioned <<First Embodiment>> can be used.

### (Bonding Step)

It is preferable to perform a bonding step between the adhesive coating layer forming step and the adhesive layer forming step in order to sufficiently bond the semiconductor substrate and the support substrate.

As the bonding step, the same conditions as described in the aforementioned <<First Embodiment>> can be used.

### (Method for Producing Semiconductor Substrate)

The laminate of the present invention is used for temporary adhesion in order to process a semiconductor substrate, and can be suitably used for an application in which a support substrate and a semiconductor substrate are separated from each other after processing of the semiconductor substrate in the laminate.

The method for producing a semiconductor substrate according to the present invention includes at least a processing step of processing the semiconductor substrate and a debonding step of separating the support substrate and the processed semiconductor substrate, and further includes other steps such as a removal step as necessary.

### <Processing Step>

The processing step is not particularly limited as long as it is a step of processing the semiconductor substrate in the laminate according to the present invention, and includes, for example, a polishing treatment, a through electrode forming process, and the like.

For example, in various processing steps, processing may be performed under high temperature and high pressure, but the laminate of the present invention can effectively prevent bump deformation of the semiconductor substrate even when processed under high temperature (for example, 250 to 350°C) or high pressure.

### <<Polishing Treatment>>

The polishing treatment is not particularly limited as long as it is a treatment of polishing a surface of the semiconductor substrate opposite to a surface where the bumps are present to thin the semiconductor substrate, and examples thereof include physical polishing using a polishing agent or a grindstone, and the like.

The polishing treatment can be performed using a general polishing device used for polishing a semiconductor substrate.

By the polishing treatment, the thickness of the semiconductor substrate is reduced, and a semiconductor substrate thinned to a desired thickness is obtained. The thickness of the thinned semiconductor substrate is not particularly limited, but may be, for example, 30 to 300 um or 30 to 100 µm.

### <<Through Electrode Forming Step>>

A through electrode for achieving conduction between the thinned semiconductor substrates when a plurality of thinned semiconductor substrates are laminated may be formed on the polished semiconductor substrate.

Therefore, the method for producing the semiconductor substrate may include a through electrode forming process of forming a through electrode on the polished semiconductor substrate after the polishing treatment and before the debonding step.

The method for forming a through electrode on the semiconductor substrate is not particularly limited, and examples thereof include forming a through hole and filling the formed through hole with a conductive material.

The through hole is formed by, for example, photolithography.

The filling of the conductive material into the through hole is performed by, for example, a plating technique.

### <Debonding Step>

The debonding step is not particularly limited as long as it is a step of separating the support substrate and the processed semiconductor substrate after the processing step.

Examples thereof include, but are not limited to, solvent debonding, debonding by light irradiation (laser light, non-laser light), mechanical debonding by means of a machine member having a sharp part (so-called a debonder), manual debonding between a support and a wafer, and the like. Debonding is generally performed after the laminate of the present invention is produced and subjected to predetermined processing or the like.

In particular, in the case where the laminate includes a release layer and the release layer is a release layer formed using an organic resin that absorbs light and causes deterioration necessary for improvement of debonding ability as described above, the release layer can be debonded off by, for example, irradiating laser from the support side.

The wavelength of the laser light is performed using ultraviolet light with a wavelength of 190 nm to 400 nm or 190 nm to 600 nm (for example, 308 nm, 355 nm, 532 nm).

Debonding can be performed by setting the processing energy density of the pulse laser to about 50 to 500 mJ/cm².

In the case where the laminate includes a release layer, debonding generally occurs inside the release layer or at an interface between the release layer and an adjacent substrate or layer (for example, an adhesive layer). The fact that debonding occurs inside the release layer means that the release layer is cleaved.

### <Other Steps>

### <<Removal Step>>

The removal step is not particularly limited as long as it is a step of removing the adhesive layer after the debonding step, and examples thereof include a method of dissolving and removing the adhesive layer using a detergent composition. In addition, removal using a removal tape or the like may be combined with dissolution removal.

When the detergent composition is used, for example, the semiconductor substrate with an adhesive layer can be immersed in the detergent composition, or the detergent composition can be sprayed.

Since the adhesive obtained by forming the adhesive composition of the present invention exhibits a high etching rate as shown in the following Examples, the laminate of the present invention can easily dissolve and remove the adhesive layer left on the semiconductor substrate after the debonding step.

A suitable example of the detergent composition used in the present invention is a detergent composition containing a quaternary ammonium salt and a solvent.

The quaternary ammonium salt is composed of a quaternary ammonium cation and an anion, and is not particularly limited as long as it is used for this type of application.

Such a quaternary ammonium cation typically includes a tetra(hydrocarbon) ammonium cation. On the other hand, an anion paired therewith includes, but is not limited to, a hydroxide ion (OH⁻); halogen ions such as a fluorine ion (F⁻), a chlorine ion (Cl⁻), a bromine ion (Br⁻), and an iodine ion (I-) ; tetrafluoroborate ion (BF₄-); hexafluorophosphate ions (PF₆⁻), and the like.

In the present invention, the quaternary ammonium salt is preferably a halogen-containing quaternary ammonium salt, and more preferably a fluorine-containing quaternary ammonium salt.

In the quaternary ammonium salt, the halogen atom may be contained in the cation or the anion, but is preferably contained in the anion.

In a preferred embodiment, the fluorine-containing quaternary ammonium salt is tetra(hydrocarbon) ammonium fluoride.

Specific examples of the hydrocarbon group in tetra(hydrocarbon) ammonium fluoride include an alkyl group having 1 to 20 carbon atoms, an alkenyl group having 2 to 20 carbon atoms, an alkynyl group having 2 to 20 carbon atoms, an aryl group having 6 to 20 carbon atoms, and the like.

In a more preferred embodiment, the tetra(hydrocarbon) ammonium fluoride includes tetraalkylammonium fluoride.

Specific examples of tetraalkylammonium fluoride include, but are not limited to, tetramethylammonium fluoride, tetraethylammonium fluoride, tetrapropylammonium fluoride, tetrabutylammonium fluoride (also referred to as tetrabutylammonium fluoride), and the like. Among them, tetrabutylammonium fluoride is preferred.

An example of an embodiment of producing a laminate and producing a thinned wafer are performed in series will be described with reference to Figs. 2A to 2F.

Figs. 2A to 2F are views for explaining an embodiment of producing a laminate and producing a thinned wafer.

First, a wafer 1 having bumps 1a is prepared (Fig. 2A) .

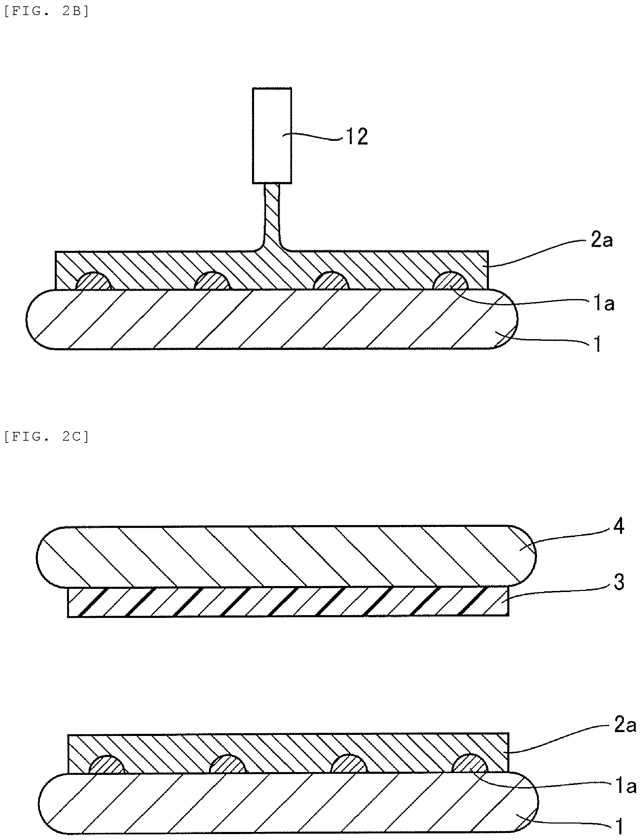

Next, the adhesive composition is applied onto a surface of the wafer 1 where the bumps 1a are present by spin coating using the coating device 12 to form an adhesive coating layer 2a (Fig. 2B).

Next, the release agent composition is applied onto the support substrate 4 by spin coating using a coating device (not illustrated), and the release agent composition is cured by heating to form the release layer 3, thereby preparing the support substrate 4 on which the release layer 3 is formed (Fig. 2C).

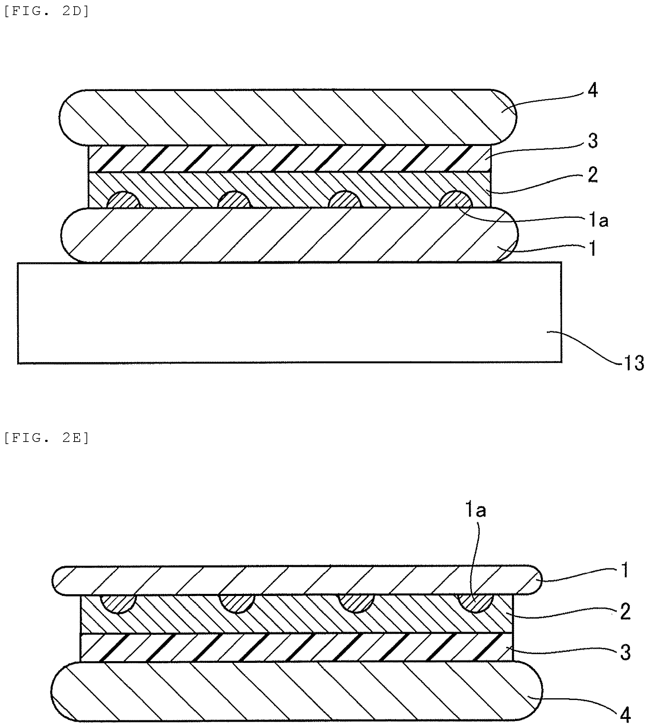

Next, the wafer 1 on which the adhesive coating layer 2a is formed and the support substrate 4 on which the release layer 3 is formed are bonded to each other under reduced pressure so as to sandwich the adhesive coating layer 2a and the release layer 3, and then a heating device (hot plate) 13 is arranged on a surface of the wafer 1 opposite to a surface where the bumps 1a are present, and the adhesive coating layer 2a is heated by the heating device 13 to cure the adhesive composition and convert the adhesive composition into the adhesive layer 2 (Fig. 2D).

A laminate is obtained by the steps shown in Figs. 2A to 2D.

Next, an example of producing a thinned wafer will be described.

Next, the surface of the wafer 1 opposite to the surface where the bumps 1a are present is polished using a polishing device (not illustrated) to thin the wafer 1 (Fig. 2E). A through electrode may be formed on the thinned wafer 1.

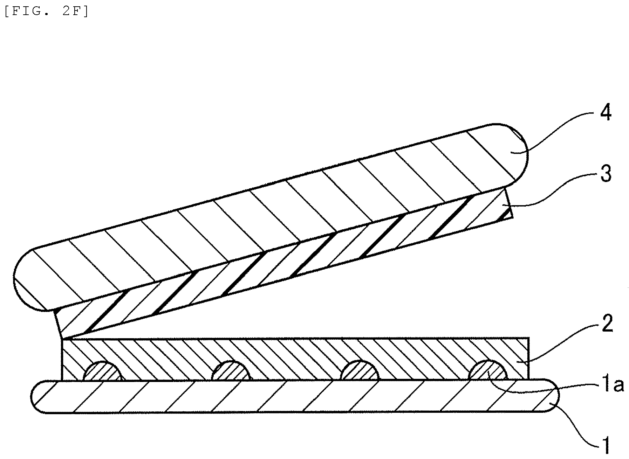

Next, the thinned wafer 1 and the support substrate 4 are debonded by irradiating (not illustrated) light (ultraviolet light) from the support substrate 4 side (Fig. 2F). At this time, the adhesive layer 2 and the release layer 3 are debonded, so that the thinned wafer 1 and the support substrate 4 are debonded.

Next, the thinned wafer 1 is cleaned by dissolving and removing the adhesive layer 2 from the wafer 1 thinned by the detergent composition using a cleaning device (not illustrated).

As described above, the thinned wafer 1 is obtained.

### Examples

Hereinafter, the present invention will be described more specifically with reference to Examples, but the present invention is not limited to the following Examples. The apparatuses used are as follows.

### [Apparatuses]

(1) Agitator A: Planetary centrifugal mixer ARE-500 manufactured by Thinky Corporation
(2) Viscometer: Rotary viscometer TVE-22H manufactured by Toki Sangyo Co., Ltd
(3) Complex viscometer: Rheometer MCR-302 manufactured by Anton Paar GmbH.
(4) Agitator H: Heating rocking mixer HRM-1 manufactured by As One Corporation
(5) Contact type film thickness meter: Wafer thickness measuring system WT-425 manufactured by Tokyo Seimitsu Co., Ltd.
(6) Optical film thickness meter (film thickness measurement): F-50 manufactured by Filmetrics, Inc.
(7) Vacuum bonding apparatus: manufactured by SUSS MicroTec SE, auto bonder
(8) High rigid grinder: HRG300 manufactured by Tokyo Seimitsu Co., Ltd.
(9) Dicing machine: SS30 manufactured by Tokyo Seimitsu Co., Ltd.
(10) Thermocompression bonding equipment: manufactured by Ayumi INDUSTRY CO., LTD., attachment device

### [Measurement of Molecular Weight]

The weight average molecular weight, number average molecular weight, and dispersion degree of polyorganosiloxane were measured using a GPC apparatus (EcoSEC HLC-8320GPC manufactured by Tosoh Corporation) and a GPC column (TSKgel SuperMultipore HZ-N and TSKgel SuperMultipore HZ-H manufactured by Tosoh Corporation), at a column temperature of 40°C and a flow rate of 0.35 mL/min by use of tetrahydrofuran as an eluent (elution solvent) and polystyrene (Shodex manufactured by Showa Denko K.K.) as a standard sample.

Structural formulas of the components used in Examples are shown below. 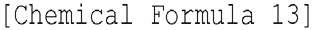 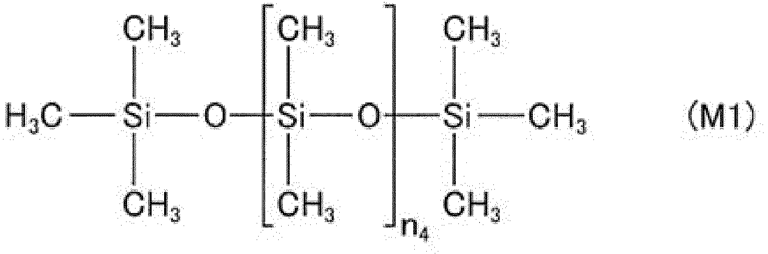 (wherein n₄ represents the number of repeating units, and is a positive integer) 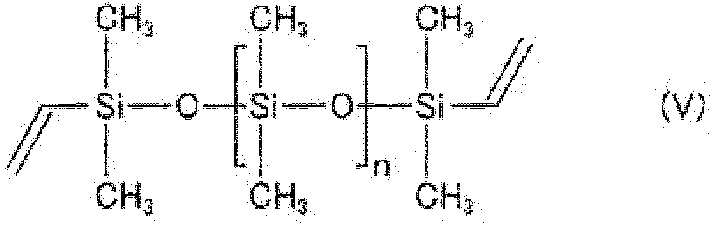 (wherein n represents the number of repeating units, and is a positive integer) 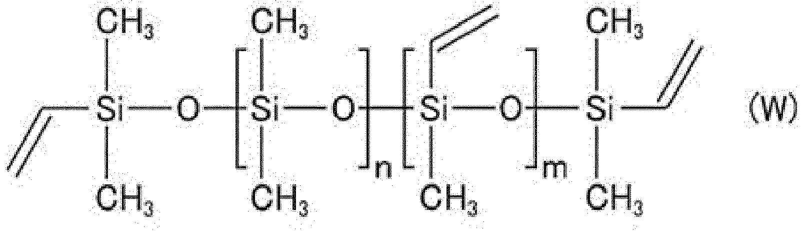 (wherein each of n and m -represents the number of repeating units, and is a positive integer)

### [1] Preparation of Adhesive Composition

### [Preparation Example 1-1]

To a 300-mL agitation container dedicated to a planetary centrifugal mixer were added 62.05 g of a p-menthane solution (concentration: 80.6% by mass) of a vinyl group-containing MQ resin (manufactured by Wacker Chemie AG) serving as the aforementioned component (a1) and 0.25 g of 1,1-diphenyl-2-propyn-1-ol (manufactured by Tokyo Chemical Industry Co., Ltd.) serving as the aforementioned component (A3), and the resultant mixture was agitated by Agitator A for 5 minutes to obtain a mixture (I).

To the obtained mixture (I) were added 10.09 g of a polyorganosiloxane represented by formula (M1) (complex viscosity 6,000 Pa · s, weight average molecular weight 642,000 (dispersion degree 2.6), trade name GENIOPLASTGUM manufactured by Wacker Chemie AG) serving as the aforementioned component (B), 30.17 g of a vinyl group-containing linear polydimethylsiloxane having a viscosity of 100,000 mPa · s represented by formula (V) (manufactured by Wacker Chemie AG) (hereinafter, also referred to as a vinyl group-containing linear polydimethylsiloxane v1) serving as the aforementioned component (a1), 8.33 g of an SiH group-containing linear polydimethylsiloxane having a viscosity of 100 mPa · s (manufactured by Wacker Chemie AG) serving as the aforementioned component (a2), and 24.56 g of p-menthane (manufactured by Nippon Terpene Chemicals, Inc.) serving as a solvent, and 0.26 g of 1-ethynyl-1-cyclohexanol (manufactured by Wacker Chemie AG) serving as the aforementioned component (A3) was further added thereto, and the resultant mixture was further agitated by Agitator A for 10 minutes to obtain a mixture (II).

0.10 g of a platinum catalyst (manufactured by Wacker Chemie AG) serving as the aforementioned component (A2) and 28.96 g of a vinyl group-containing linear polydimethylsiloxane having a viscosity of 200 mPa · s represented by formula (V) (manufactured by Wacker Chemie AG) (hereinafter, also referred to as a vinyl group-containing linear polydimethylsiloxane v2) serving as the aforementioned component (a1) were agitated by Agitator A for 5 minutes to obtain a mixture (III).

11.76 g of the obtained mixture (III) was added to the mixture (II), and the mixture was agitated by Agitator A for 5 minutes to obtain a mixture (IV).

Finally, the obtained mixture (IV) was filtered through a nylon filter 300 mesh to obtain an adhesive composition. The viscosity of the adhesive composition measured using a rotary viscometer was 3,600 mPa · s.

The weight average molecular weight of the polymer represented by formula (V) contained in the adhesive composition was 109,381, and Mw/Mn was 11.5.

### [Preparation Example 1-2]

To a 150-mL agitation container dedicated to a planetary centrifugal mixer were added 35.30 g of a p-menthane solution (concentration: 85.1% by mass) of a vinyl group-containing MQ resin (manufactured by Wacker Chemie AG) serving as the aforementioned component (a1) and 0.15 g of 1,1-diphenyl-2-propyn-1-ol (manufactured by Tokyo Chemical Industry Co., Ltd.) serving as the aforementioned component (A3), and the resultant mixture was agitated by Agitator A for 5 minutes to obtain a mixture (I).

To the obtained mixture (I) were added 10.01 g of a p-menthane solution (concentration: 60.3% by mass) of polyorganosiloxane represented by formula (M1) (complex viscosity 6,000 Pa · s, weight average molecular weight 642,000 (dispersion degree 2.6), trade name GENIOPLASTGUM manufactured by Wacker Chemie AG) serving as the aforementioned component (B), 24.08 g of a vinyl group-containing linear polydimethylsiloxane having a viscosity of 100,000 mPa · s represented by formula (V) (manufactured by Wacker Chemie AG) serving as the aforementioned component (a1), 5.00 g of an SiH group-containing linear polydimethylsiloxane having a viscosity of 100 mPa · s (manufactured by Wacker Chemie AG) serving as the aforementioned component (a2), and 13.02 g of p-menthane (manufactured by Nippon Terpene Chemicals, Inc.) serving as a solvent, and 0.15 g of 1-ethynyl-1-cyclohexanol (manufactured by Wacker Chemie AG) serving as the aforementioned component (A3) was further added thereto, and the resultant mixture was further agitated by Agitator A for 10 minutes to obtain a mixture (II).

0.03 g of a platinum catalyst (manufactured by Wacker Chemie AG) serving as the aforementioned component (A2) and 1.53 g of the vinyl group-containing linear polydimethylsiloxane having a viscosity of 200 mPa · s represented by formula (V) (manufactured by Wacker Chemie AG) serving as the aforementioned component (a1) were agitated by Agitator A for 5 minutes to obtain a mixture (III) .

1.04 g of the obtained mixture (III) was added to the mixture (II), and the mixture was agitated by Agitator A for 5 minutes to obtain a mixture (IV).

Finally, the obtained mixture (IV) was filtered through a nylon filter 300 mesh to obtain an adhesive composition. The viscosity of the adhesive composition measured using a rotary viscometer was 5,200 mPa · s.

The weight average molecular weight of the polymer represented by formula (V) contained in the adhesive composition was 130,814, and Mw/Mn was 3.27.

### [Preparation Example 1-3]

To a 150-mL agitation container dedicated to a planetary centrifugal mixer were added 35.31 g of a p-menthane solution (concentration: 85.1% by mass) of a vinyl group-containing MQ resin (manufactured by Wacker Chemie AG) serving as the aforementioned component (a1) and 0.15 g of 1,1-diphenyl-2-propyn-1-ol (manufactured by Tokyo Chemical Industry Co., Ltd.) serving as the aforementioned component (A3), and the resultant mixture was agitated by Agitator A for 5 minutes to obtain a mixture (I).

To the obtained mixture (I) were added 10.02 g of a p-menthane solution (concentration: 60.3% by mass) of polyorganosiloxane represented by formula (M1) (complex viscosity 6,000 Pa · s, weight average molecular weight 642,000 (dispersion degree 2.6), trade name GENIOPLASTGUM manufactured by Wacker Chemie AG) serving as the aforementioned component (B), 12.02 g of a vinyl group-containing linear polydimethylsiloxane having a viscosity of 100,000 mPa · s represented by formula (V) (manufactured by Wacker Chemie AG) serving as the aforementioned component (a1), 5.00 g of an SiH group-containing linear polydimethylsiloxane having a viscosity of 100 mPa · s (manufactured by Wacker Chemie AG) serving as the aforementioned component (a2), and 13.00 g of p-menthane (manufactured by Nippon Terpene Chemicals, Inc.) serving as a solvent, and 0.15 g of 1-ethynyl-1-cyclohexanol (manufactured by Wacker Chemie AG) serving as the aforementioned component (A3) was further added thereto, and the resultant mixture was further agitated by Agitator A for 10 minutes to obtain a mixture (II).

0.03 g of a platinum catalyst (manufactured by Wacker Chemie AG) serving as the aforementioned component (A2) and 19.54 g of the vinyl group-containing linear polydimethylsiloxane having a viscosity of 200 mPa · s represented by formula (V) (manufactured by Wacker Chemie AG) serving as the aforementioned component (a1) were agitated by Agitator A for 5 minutes to obtain a mixture (III) .

13.04 g of the obtained mixture (III) was added to the mixture (II), and the mixture was agitated by Agitator A for 5 minutes to obtain a mixture (IV).

Finally, the obtained mixture (IV) was filtered through a nylon filter 300 mesh to obtain an adhesive composition. The viscosity of the adhesive composition measured using a rotary viscometer was 1,800 mPa · s.

The weight average molecular weight of the polymer represented by formula (V) contained in the adhesive composition was 67,931, and Mw/Mn was 22.42.

### [Comparative Preparation Example 1-1]

In a 600-mL agitation container dedicated to a planetary centrifugal mixer were placed 150 g of a mixture (85.5/64.5 (w/w)) of a vinyl group-containing linear polydimethylsiloxane having a viscosity of 200 mPa · s represented by formula (V) (manufactured by Wacker Chemie AG) and an MQ resin having a polysiloxane skeleton and a vinyl group (manufactured by Wacker Chemie AG) serving as the aforementioned component (a1), 15.81 g of an SiH group-containing linear polydimethylsiloxane having a viscosity of 100 mPa · s (manufactured by Wacker Chemie AG) serving as the aforementioned component (a2), and 0.17 g of 1-ethynyl-1-cyclohexanol (manufactured by Wacker Chemie AG) serving as the aforementioned component (A3), and the resultant mixture was agitated by Agitator A for 5 minutes to obtain a mixture (I).

In a 50-mL screw tube were placed 0.33 g of a platinum catalyst (manufactured by Wacker Chemie AG) serving as the aforementioned component (A2) and 9.98 g of a vinyl group-containing linear polydimethylsiloxane having a viscosity of 1,000 mPa · s represented by formula (W) (manufactured by Wacker Chemie AG) (hereinafter, also referred to as a vinyl group-containing linear polydimethylsiloxane v3) serving as the aforementioned component (a1), and the resultant mixture was agitated by Agitator A for 5 minutes to obtain a mixture (II).

0.52 g of the obtained mixture (II) was added to the mixture (I), and the mixture was agitated by Agitator A for 5 minutes to obtain a mixture (III).

Finally, the obtained mixture (III) was filtered through a nylon filter 300 mesh to obtain an adhesive composition. The viscosity of the adhesive composition measured using a rotary viscometer was 9,900 mPa · s.

### [Comparative Preparation Example 1-2]

To a 600-mL agitation container dedicated to a planetary centrifugal mixer were added 104.14 g of a p-menthane solution (concentration: 80.6% by mass) of an MQ resin having a polysiloxane skeleton and a vinyl group (manufactured by Wacker Chemie AG) serving as the aforementioned component (a1), 58.11 g of a polyorganosiloxane represented by formula (M1) (complex viscosity: 800 Pa · s manufactured by Wacker Chemie AG) serving as the aforementioned component (B), 34.94 g of p-menthane (manufactured by Nippon Terpene Chemical Co., Ltd.) serving as a solvent, and 6.20 g of n-decane (manufactured by Sankyo Chemical Co., Ltd.), and the resultant mixture was agitated by Agitator A for 5 minutes to obtain a mixture (I).

To the obtained mixture (I) were added 16.79 g of an SiH group-containing linear polydimethylsiloxane having a viscosity of 100 mPa · s (manufactured by Wacker Chemie AG) serving as the aforementioned component (a2) and 24.54 g of a vinyl group-containing linear polydimethylsiloxane having a viscosity of 200 mPa · s represented by formula (V) (manufactured by Wacker Chemie AG) serving as the aforementioned component (a1), and the resultant mixture was agitated by Agitator A for 5 minutes to obtain a mixture (II).

1.61 g of 1,1-diphenyl-2-propyn-1-ol (manufactured by Tokyo Chemical Industry Co., Ltd.) and 1.61 g of 1-ethynyl-1-cyclohexanol (manufactured by Wacker Chemie AG) serving as the aforementioned components (A3) and 3.23 g of p-menthane (manufactured by Nippon Terpene Chemical Co., Ltd.) serving as a solvent were agitated by Agitator A for 60 minutes to obtain a mixture (III).

1.29 g of the obtained mixture (III) was added to the mixture (II), and the mixture was agitated by Agitator A for 5 minutes to obtain a mixture (IV).

0.65 g of a platinum catalyst (manufactured by Wacker Chemie AG) serving as the aforementioned component (A2) and 19.37 g of a vinyl group-containing linear polydimethylsiloxane having a viscosity of 1,000 mPa · s represented by formula (W) (manufactured by Wacker Chemie AG) serving as the aforementioned component (a1) were agitated by Agitator A for 5 minutes to obtain a mixture (V) .

4.00 g of the obtained mixture (V) was added to the mixture (IV), and the mixture was agitated by Agitator A for 5 minutes to obtain a mixture (VI).

Finally, the obtained mixture (VI) was filtered through a nylon filter 300 mesh to obtain an adhesive composition. The viscosity of the adhesive composition measured using a rotary viscometer was 3,000 mPa · s.

### [Comparative Preparation Example 1-3]

To a 200-mL agitation container dedicated to a planetary centrifugal mixer were added 35.32 g of a p-menthane solution (concentration: 85.1% by mass) of a vinyl group-containing MQ resin (manufactured by Wacker Chemie AG) serving as the aforementioned component (a1) and 0.15 g of 1,1-diphenyl-2-propyn-1-ol (manufactured by Tokyo Chemical Industry Co., Ltd.) serving as the aforementioned component (A3), and the resultant mixture was agitated by Agitator A for 5 minutes to obtain a mixture (I).

To the obtained mixture (I) were added 10.03 g of a p-menthane solution (concentration: 60.3% by mass) of polyorganosiloxane represented by formula (M1) (complex viscosity 6,000 Pa · s, weight average molecular weight 642,000 (dispersion degree 2.6), trade name GENIOPLASTGUM manufactured by Wacker Chemie AG) serving as the aforementioned component (B), 24.06 g of a vinyl group-containing linear polydimethylsiloxane having a viscosity of 200 mPa · s represented by formula (V) (manufactured by Wacker Chemie AG) serving as the aforementioned component (a1), 4.98 g of an SiH group-containing linear polydimethylsiloxane having a viscosity of 100 mPa · s (manufactured by Wacker Chemie AG) serving as the aforementioned component (a2), and 13.00 g of p-menthane (manufactured by Nippon Terpene Chemicals, Inc.) serving as a solvent, and 0.16 g of 1-ethynyl-1-cyclohexanol (manufactured by Wacker Chemie AG) serving as the aforementioned component (A3) was further added thereto, and the resultant mixture was further agitated by Agitator A for 10 minutes to obtain a mixture (II).

0.027 g of a platinum catalyst (manufactured by Wacker Chemie AG) serving as the aforementioned component (A2) and 1.54 g of the vinyl group-containing linear polydimethylsiloxane having a viscosity of 200 mPa · s represented by formula (V) (manufactured by Wacker Chemie AG) serving as the aforementioned component (a1) were agitated by Agitator A for 5 minutes to obtain a mixture (III) .

1.04 g of the obtained mixture (III) was added to the mixture (II), and the mixture was agitated by Agitator A for 5 minutes to obtain a mixture (IV).

Finally, the obtained mixture (IV) was filtered through a nylon filter 300 mesh to obtain an adhesive composition. The viscosity of the adhesive composition measured using a rotary viscometer was 610 mPa · s.

### [Comparative Preparation Example 1-4]

To a 200-mL agitation container dedicated to a planetary centrifugal mixer were added 35.27 g of a p-menthane solution (concentration: 85.1% by mass) of a vinyl group-containing MQ resin (manufactured by Wacker Chemie AG) serving as the aforementioned component (a1) and 0.15 g of 1,1-diphenyl-2-propyn-1-ol (manufactured by Tokyo Chemical Industry Co., Ltd.) serving as the aforementioned component (A3), and the resultant mixture was agitated by Agitator A for 5 minutes to obtain a mixture (I).

To the obtained mixture (I) were added 10.01 g of a p-menthane solution (concentration: 60.3% by mass) of polyorganosiloxane represented by formula (M1) (complex viscosity 6,000 Pa · s, weight average molecular weight 642,000 (dispersion degree 2.6), trade name GENIOPLASTGUM manufactured by Wacker Chemie AG) serving as the aforementioned component (B), 18.00 g of a vinyl group-containing linear polydimethylsiloxane having a viscosity of 1,000 mPa · s represented by formula (W) (manufactured by Wacker Chemie AG) serving as the aforementioned component (a1), 4.98 g of an SiH group-containing linear polydimethylsiloxane having a viscosity of 100 mPa · s (manufactured by Wacker Chemie AG) serving as the aforementioned component (a2), and 13.00 g of p-menthane (manufactured by Nippon Terpene Chemicals, Inc.) serving as a solvent, and 0.16 g of 1-ethynyl-1-cyclohexanol (manufactured by Wacker Chemie AG) serving as the aforementioned component (A3) was further added thereto, and the resultant mixture was further agitated by Agitator A for 10 minutes to obtain a mixture (II).

0.028 g of a platinum catalyst (manufactured by Wacker Chemie AG) serving as the aforementioned component (A2) and 10.54 g of the vinyl group-containing linear polydimethylsiloxane having a viscosity of 200 mPa · s represented by formula (V) (manufactured by Wacker Chemie AG) serving as the aforementioned component (a1) were agitated by Agitator A for 5 minutes to obtain a mixture (III) .

7.06 g of the obtained mixture (III) was added to the mixture (II), and the mixture was agitated by Agitator A for 5 minutes to obtain a mixture (IV).

Finally, the obtained mixture (IV) was filtered through a nylon filter 300 mesh to obtain an adhesive composition. The viscosity of the adhesive composition measured using a rotary viscometer was 820 mPa · s.

The measurement results of the molecular weights of the vinyl group-containing linear polydimethylsiloxane v1, the vinyl group-containing linear polydimethylsiloxane v2, and the vinyl group-containing linear polydimethylsiloxane v3 used in Preparation Examples 1-1 to 1-3 and Comparative Preparation Examples 1-1 to 1-4 are shown in Table 1 below.

**[Table 1]**

| Vinylgroup-containing linear polydimethylsiloxane | Number average molecular weight Mn | Weight average molecular weight Mw | Mw/Mn |
|---|---|---|---|
| v2 | 85 15 | 16187 | 1.92 |
| v3 | 14596 | 35662 | 2.45 |
| v1 | 83236 | 153801 | 1.85 |

### [2] Preparation of Release Agent Composition

### [Preparation Example 2]

56.02 g of N-phenyl-1-naphthylamine, 50.00 g of 1-pyrenecarboxaldehyde, 6.67 g of 4-(trifluoromethyl)benzaldehyde, and 2.46 g of methanesulfonic acid were placed in a flask, 86.36 g of 1,4-dioxane and 86.36 g of toluene were added thereto, and the resultant mixture was refluxed and agitated for 18 hours under a nitrogen atmosphere.

After the reaction mixture was allowed to cool, 96 g of tetrahydrofuran was added thereto for dilution, and the resulting diluted solution was added dropwise to methanol to obtain a precipitate. The obtained precipitate was collected by filtration, and the filtrate was washed with methanol and dried at 60°C under reduced pressure to obtain 72.12 g of a novolac resin.

The weight average molecular weight of the novolac resin as a polymer measured in terms of polystyrene by GPC was 1,100.

3.6 g of the obtained novolac resin, 0.72 g of a compound represented by formula (L) below (trade name: TMOM-BP, manufactured by Honshu Chemical Industry Co., Ltd.) as a crosslinking agent, and 0.1 g of pyridinium paratoluenesulfonate were dissolved in 95.58 g of propylene glycol monomethyl ether acetate, and the resulting solution was filtered using a polyethylene microfilter with a pore size of 0.2 um to obtain a release agent composition.

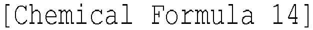

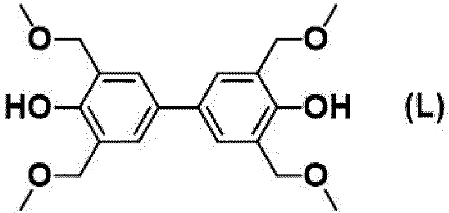

### [3] Preparation of Detergent Composition

### [Preparation Example 3]

95 g of N,N-dimethylpropionamide was added to 5 g of tetrabutylammonium fluoride trihydrate (manufactured by KANTO CHEMICAL CO., INC.), and the resulting mixture was agitated to obtain a detergent composition.

### [4] Evaluation of Removability of Adhesive Layer

In order to evaluate removability of the adhesive layer obtained from the adhesive composition by cleaning, an etching rate was measured.

The adhesive compositions obtained in Preparation Examples 1-1 to 1-3 and Comparative Preparation Examples 1-1 to 1-4 were each applied to a 12 inch silicon wafer with a spin coater, and heated at 200°C for 10 minutes to form adhesive layers (thickness: 100 pm). Then, the wafer with film (adhesive layer) formation was cut into a 4 cm square chip, and the film thickness was measured using a contact type film thickness meter. Thereafter, the chip was placed in a stainless steel petri dish with a diameter of 9 cm, 7 mL of the detergent composition obtained in Preparation Example 3 was added thereto, and the stainless steel dish was covered with a lid, then the stainless steel dish was placed on Agitator H, and agitated and cleaned at 23°C for 5 minutes.

After cleaning, the chip was taken out, cleaned with isopropanol and pure water, and dried at 120°C for 1 minute, and the film thickness was measured again with a contact type film thickness meter. Then, the film thickness reduction was calculated before and after cleaning, and the etching rate [pm/min] was calculated by dividing the reduced amount by the cleaning time, and used as an index of detergency. The results are shown in Table 2 below.

**[Table 2]**

| | Etch ing rate [µm/min] |
|---|---|
| Preparation Exam p le 1- 1 | 16.4 |
| Preparation Example 1-2 | 18.4 |
| Preparation Example 1-3 | 14.2 |
| Com parative Preparation Exam p le 1- 1 | 11.0 |
| Comparative Preparation Example 1- 2 | 16.5 |
| Comparative Preparation Example 1-3 | 12.9 |
| Comparative Preparation Example 1- 4 | 12.0 |

It was confirmed that the adhesive layer obtained from the adhesive composition of the present invention exhibited a high etching rate with respect to the detergent composition, and could be suitably removed with the detergent composition.

### [5] Adhesion Test

### [5-1] Preparation of Laminate

### [Example 1-1]

The adhesive composition obtained in Preparation Example 1-1 was applied by spin coating to a 300 mm silicon wafer (thickness: 770 um) as a device-side wafer (semiconductor substrate), and heated at 120°C for 1.5 minutes (pre-heat treatment) to form an adhesive coating layer on a circuit surface of the silicon wafer so that the final thickness of the adhesive layer in the laminate was about 65 um.

On the other hand, the release agent composition obtained in Preparation Example 2 was applied to a 300 mm glass wafer (thickness: 700 um) as a carrier side wafer (support) by spin coating, and heated at 250°C for 5 minutes to form a release layer on the glass wafer so that the final thickness of the release layer in the laminate was about 200 nm.

Thereafter, in a vacuum bonding apparatus, the semiconductor substrate and the support substrate were bonded so as to sandwich the adhesive coating layer and the release layer, and heated on a hot plate at 200°C for 10 minutes with the semiconductor substrate side facing down (post-heat treatment) to prepare a laminate. Bonding was performed under a load of 30 N at a temperature of 23°C and a degree of pressure reduction of 1,000 Pa.

### [Example 1-2]

A laminate was prepared in the same manner as in Example 1-1, except that the adhesive composition obtained in Preparation Example 1-2 was used in place of the adhesive composition obtained in Preparation Example 1-1.

### [Example 1-3]

A laminate was prepared in the same manner as in Example 1-1, except that the adhesive composition obtained in Preparation Example 1-3 was used in place of the adhesive composition obtained in Preparation Example 1-1.

### [Comparative Example 1-1]

The adhesive composition obtained in Comparative Preparation Example 1-1 was applied by spin coating to a 300 mm silicon wafer (thickness: 770 um) as a device-side wafer (semiconductor substrate) to form an adhesive coating layer on a circuit surface of the silicon wafer so that the final thickness in the laminate was about 65 um.

Then, a release agent coating layer was formed and the semiconductor substrate and the support substrate were bonded to each other under the same conditions as in Example 1-1 to prepare a laminate.

### [Comparative Example 1-2]

The adhesive composition obtained in Comparative Preparation Example 1-2 was applied by spin coating to a 300 mm silicon wafer (thickness: 770 um) as a device-side wafer (semiconductor substrate), and heated at 110°C for 1.5 minutes (pre-heat treatment) to form an adhesive coating layer on a circuit surface of the silicon wafer so that the final thickness of the adhesive layer in the laminate was about 65 um.

Then, a release agent coating layer was formed and the semiconductor substrate and the support substrate were bonded to each other under the same conditions as in Example 1-1 except that the time for the post-heat treatment was changed to 9 minutes to prepare a laminate.

### [Comparative Example 1-3]

A laminate was prepared in the same manner as in Example 1-1, except that the adhesive composition obtained in Comparative Preparation Example 1-3 was used in place of the adhesive composition obtained in Preparation Example 1-1.

### [Comparative Example 1-4]

A laminate was prepared in the same manner as in Example 1-1, except that the adhesive composition obtained in Comparative Preparation Example 1-4 was used in place of the adhesive composition obtained in Preparation Example 1-1.

### [5-2] Evaluation of Adhesiveness

The adhesiveness was evaluated by visually confirming the presence or absence of voids from the glass wafer (support) side of the laminate.

When no void was confirmed, it was evaluated as good, and when a void was confirmed, it was evaluated as poor.

As a result, no void was confirmed in the laminates obtained in Examples 1-1 to 1-3 and Comparative Examples 1-1 to 1-4.

### [6] High Temperature and High Pressure Treatment Test

### [6-1] Preparation of Laminate

### [Example 2-1]

A laminate was prepared in the same manner as in Example 1-1, except that a PI TEG 300 mm silicon wafer (thickness: 770 um, bump diameter: 0.03 mm, bump height: 0.04 mm, bump pitch: 0.06 × 0.1 mm) was used in place of the 300 mm silicon wafer (thickness: 770 µm).

The silicon wafer of the obtained laminate was thinned to a thickness of 50 um with a high rigidity grinder, and then attached to a dicing tape (DU-300 manufactured by Nitto Denko Corporation) with the thinned silicon wafer side facing down, and fixed.

The fixed laminate was cut into a size of 4 cm × 4 cm by a dicing machine, and cut into chips of a 4 cm square laminate to be used in a high temperature and high pressure treatment test.

### [Example 2-2]

Chips of a 4 cm square laminate were cut out in the same manner as in Example 2-1 except that the adhesive composition obtained in Preparation Example 1-2 was used in place of the adhesive composition obtained in Preparation Example 1-1.

### [Example 2-3]

Chips of a 4 cm square laminate were cut out in the same manner as in Example 2-1 except that the adhesive composition obtained in Preparation Example 1-3 was used in place of the adhesive composition obtained in Preparation Example 1-1.

### [Comparative Example 2-1]

Chips of a 4 cm square laminate were cut out in the same manner as in Example 2-1 except that the adhesive composition obtained in Comparative Preparation Example 1-1 was used in place of the adhesive composition obtained in Preparation Example 1-1.

### [Comparative Example 2-2]

Chips of a 4 cm square laminate were cut out in the same manner as in Example 2-1 except that the adhesive composition obtained in Comparative Preparation Example 1-2 was used in place of the adhesive composition obtained in Preparation Example 1-1.

### [Comparative Example 2-3]

Chips of a 4 cm square laminate were cut out in the same manner as in Example 2-1 except that the adhesive composition obtained in Comparative Preparation Example 1-3 was used in place of the adhesive composition obtained in Preparation Example 1-1.

### [Comparative Example 2-4]

Chips of a 4 cm square laminate were cut out in the same manner as in Example 2-1 except that the adhesive composition obtained in Comparative Preparation Example 1-4 was used in place of the adhesive composition obtained in Preparation Example 1-1.

### [6-2] Evaluation of High Temperature and High Pressure Treatment

Using a thermocompression bonding equipment, the chips of the laminates obtained in Example 2-1, Example 2-2, Example 2-3, Comparative Example 2-1, Comparative Example 2-2, Comparative Example 2-3, and Comparative Example 2-4 were subjected to a high temperature and high pressure treatment. The treatment was performed according to the following procedure.

A glass wafer (support substrate) of chips of the laminate was placed on a stage set at 60°C with the glass wafer (support substrate) facing down, and heated from the silicon wafer (semiconductor substrate) side while applying pressure in a vertical direction of the silicon wafer and the glass wafer under thermocompression bonding conditions of a temperature of 270°C, a pressure of 160 N/cm², and a treatment time of 20 seconds.

The condition of the silicon wafer of each laminate after the treatment was observed through the glass wafer using an optical microscope, and the presence or absence of bump deformation was visually confirmed.

There were 5044 bumps in the chip of one laminate, and evaluation was performed according to the following criteria by measuring the number of deformed bumps. The results are shown in Table 3 below.

### <Evaluation Criteria>

A: The number of deformed bumps is 0
B: The number of deformed bumps is 1 to 10
C: The number of deformed bumps is 11 to 40
D: The number of deformed bumps is 41 to 70
E: The number of deformed bumps is 71 to 100
F: The number of deformed bumps is 101 or more

**[Table 3]**

| | | Bum p deformation |
|---|---|---|
| Example 2- 1 | Preparation Example 1-1 | A |
| Example 2- 2 | Preparation Example 1-2 | B |
| Example 2-3 | Preparation Example 1-3 | C |
| Com parative Example 2- 1 | Comparative Preparation Example 1-1 | A |
| Com parative Example 2-2 | Comparative Preparation Example 1- 2 | E |
| Comparative Example 2-3 | Comparative Preparation Example 1-3 | F |
| Comparative Example 2- 4 | Comparative Preparation Example 1-4 | F |

### [7] Evaluation of Laser Debonding Performance

### [7-1] Preparation of Laminate

### [Example 3-1]

The adhesive composition obtained in Preparation Example 1-1 was applied by spin coating to a 100 mm silicon wafer (thickness: 770 um) as a device-side wafer (semiconductor substrate), and heated at 120°C for 1.5 minutes (pre-heat treatment) to form an adhesive coating layer on a circuit surface of the silicon wafer so that the final thickness of the adhesive layer in the laminate was about 60 um.

On the other hand, the release agent composition obtained in Preparation Example 2 was applied to a 100 mm glass wafer (thickness: 500 um) as a carrier side wafer (support) by spin coating, and heated at 250°C for 5 minutes to form a release layer on the glass wafer so that the final thickness of the release layer in the laminate was about 200 nm.

Thereafter, in a vacuum bonding apparatus, the semiconductor substrate and the support substrate were bonded so as to sandwich the adhesive coating layer and the release layer, and heated on a hot plate at 200°C for 10 minutes with the semiconductor substrate side facing down (post-heat treatment) to prepare a laminate. Bonding was performed at a temperature of 23°C and a degree of pressure reduction of 1,000 Pa.

### [Example 3-2]

A laminate was prepared in the same manner as in Example 3-1, except that the adhesive composition obtained in Preparation Example 1-2 was used in place of the adhesive composition obtained in Preparation Example 1-1.

### [Example 3-3]

A laminate was prepared in the same manner as in Example 3-1, except that the adhesive composition obtained in Preparation Example 1-3 was used in place of the adhesive composition obtained in Preparation Example 1-1.

### [7-2] Evaluation of Laser Debonding Performance

Using a laser irradiation device, the release layer was irradiated with a laser with a wavelength of 308 nm at 300 mJ/cm² from the glass wafer side of the fixed laminate. Then, the support substrate was manually lifted to confirm whether or not debonding was possible. As a result, in each of the laminates obtained in Examples 3-1, 3-2, and 3-3, it was possible to debond without a load by lifting the support substrate.

The adhesive compositions obtained in Preparation Examples 1-1 to 1-3 contain a vinyl group-containing linear polydimethylsiloxane having a viscosity of 100,000 mPa · s represented by formula (V) (manufactured by Wacker Chemie AG) to contain a polymer (V) represented by the aforementioned formula (V) and having a weight average molecular weight of 60,000 or more.

As shown in Examples, the adhesive layers formed using the adhesive compositions obtained in Preparation Examples 1-1 to 1-3 could suitably adhere the semiconductor substrate and the support substrate, could suppress bump deformation under high temperature and high pressure, and showed a higher etching rate. In addition, in the adhesive layers formed using the adhesive compositions obtained in Preparation Examples 1-1 to 1-3, the semiconductor substrate and the support substrate could be easily debonded from each other.

The adhesive layer formed using the adhesive composition obtained in Comparative Preparation Example 1-1 could suppress bump deformation at high temperature and high pressure, but the etching rate was low. The adhesive layers formed using the adhesive compositions of Comparative Preparation Examples 1-3 and 1-4 containing the release agent component (B) showed slightly higher etching rates with respect to the adhesive composition of Comparative Preparation Example 1-1, but could not sufficiently suppress bump deformation under high temperature and high pressure. On the other hand, the adhesive compositions of Preparation Examples 1-1 to 1-3 in which the vinyl group-containing linear polydimethylsiloxane having a viscosity of 200 mPa · s represented by formula (V) or the vinyl group-containing linear polydimethylsiloxane having a viscosity of 1,000 mPa · s represented by formula (W) in the adhesive compositions of Comparative Preparation Example 1-3 and Comparative Preparation Example 1-4 was replaced by the vinyl group-containing linear polydimethylsiloxane having a viscosity of 100,000 mPa · s represented by formula (V) could achieve both an excellent bump deformation suppressing effect and a high etching rate.

The adhesive composition obtained in Preparation Example 1-3 could improve the bump deformation suppressing effect and the etching rate in a well-balanced manner as compared with the adhesive composition obtained in each Comparative Preparation Example. Moreover, in the adhesive composition obtained in Preparation Example 1-2, slight cloudiness was observed after preparation, but there was no problem in practical use, and regarding the bump deformation suppression and the etching rate, the bump deformation suppressing effect and the etching rate could be further improved as compared with the adhesive composition obtained in Preparation Example 1-3. Furthermore, in the adhesive composition obtained in Preparation Example 1-1, the number of bump deformations was set to 0 while ensuring a high etching rate similar to the adhesive composition obtained in Preparation Example 1-2, and the bump deformation suppressing effect could be further improved as compared with the adhesive composition obtained in Preparation Example 1-2.

### Industrial Applicability

According to the present invention, it is possible to suitably temporarily adhere a semiconductor substrate with bumps and a support substrate, suppress or alleviate bump deformation due to an external load such as heating, and obtain a laminate having an adhesive layer exhibiting a high etching rate, which is useful for producing a processed semiconductor substrate.

### Reference Signs List

- 1: Wafer
- 1a: Bump
- 2: Adhesive layer
- 2a: Adhesive coating layer
- 3: Release layer
- 4: Support substrate
- 12: Coating device
- 13: Heating device

## Claims

1. An adhesive composition comprising an adhesive component (S), wherein
the adhesive component (S) contains a polyorganosiloxane component (A) that is cured by hydrosilylation reaction, and
the polyorganosiloxane component (A) contains a polymer (V) represented by formula (V) below and having a weight average molecular weight of 60,000 or more. 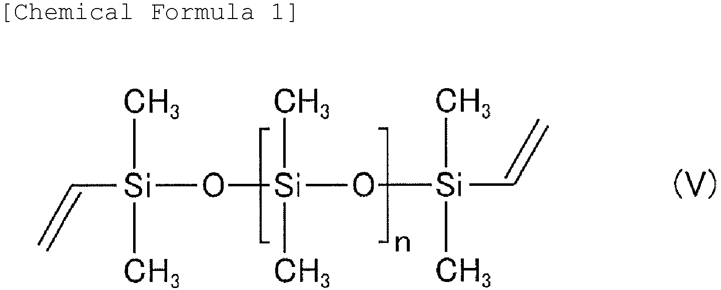
wherein n represents the number of repeating units, and is a positive integer.

2. The adhesive composition according to claim 1, comprising the adhesive component (S) and a release agent component (B) containing a polyorganosiloxane.

3. The adhesive composition according to claim 1 or 2, wherein
the polyorganosiloxane component (A) contains a polyorganosiloxane (A1) containing one or two or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T), and a platinum group metal catalyst (A2) (wherein R¹ to R⁶ are groups or atoms bonded to a silicon atom, and each independently represent an optionally substituted alkyl group, an optionally substituted alkenyl group, or a hydrogen atom),
the polyorganosiloxane (A1) contains one or two or more units selected from the group consisting of a siloxane unit represented by SiO₂ (unit Q'), a siloxane unit represented by R¹'R²'R³'SiO_{1/2} (unit M'), a siloxane unit represented by R⁴'R⁵'SiO_{2/2} (unit D'), and a siloxane unit represented by R⁶'SiO_{3/2} (unit T'), and contains a polyorganosiloxane (a1) containing at least one selected from the group consisting of the unit M', unit D', and unit T', and one or two or more units selected from the group consisting of a siloxane unit represented by SiO₂ (unit Q"), a siloxane unit represented by R¹"R²"R³"SiO_{1/2} (unit M"), a siloxane unit represented by R⁴"R⁵"SiO_{2/2} (unit D"), and a siloxane unit represented by R⁶"SiO_{3/2} (unit T"), and contains a polyorganosiloxane (a2) containing at least one selected from the group consisting of the unit M", unit D", and unit T" (wherein R¹' to R⁶' are groups bonded to a silicon atom, and each independently represent an optionally substituted alkyl group or an optionally substituted alkenyl group, but at least one of R¹' to R⁶' is an optionally substituted alkenyl group, and R¹" to R⁶" are groups or atoms bonded to a silicon atom, and each independently represent an optionally substituted alkyl group or hydrogen atom, but at least one of R¹" to R⁶" is a hydrogen atom), and
the polyorganosiloxane (a1) contains the polymer (V).

4. The adhesive composition according to any one of claims 1 to 3, wherein the weight average molecular weight of the polymer (V) is 100,000 or more.

5. The adhesive composition according to claim 2, wherein a complex viscosity of the release agent component (B) is 3,400 (Pa · s) or more.

6. The adhesive composition according to claim 5, wherein the release agent component (B) is a polyorganosiloxane represented by formula (M1) below: 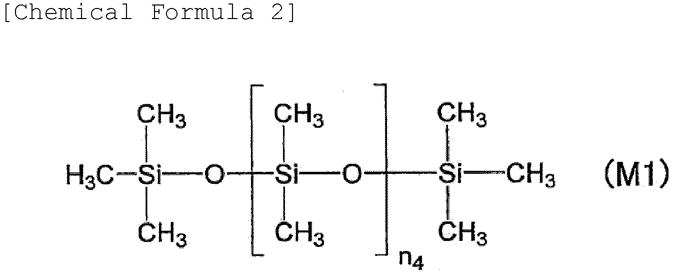 wherein n₄ represents the number of repeating units, and is a positive integer.

7. A laminate comprising an adhesive layer interposed between a semiconductor substrate with bumps and a support substrate and in contact with the semiconductor substrate, wherein
the adhesive layer is a layer formed from the adhesive composition according to any one of claims 1 to 6.

8. A method for producing a semiconductor substrate, comprising the steps of:
processing the semiconductor substrate in the laminate according to claim 7; and
separating the support substrate and the processed semiconductor substrate from each other.

9. A method for producing a laminate that produces the laminate according to claim 7, comprising the steps of:
forming an adhesive coating layer that provides the adhesive layer; and
heating the adhesive coating layer to form the adhesive layer.
